# EUROPEAN PATENT APPLICATION

(11) **EP 4 279 641 A1**
(43) Date of publication of application: **22.11.2023**
(21) Application number: 22173997.2
(22) Date of filing: 18.05.2022
(51) Int. Cl.: C30B 23/02, C30B 29/36

(54) **IMPROVED FURNACE APPARATUS FOR CRYSTAL PRODUCTION WITH SEED HOLDER REPOSITIONING UNIT**

(71) Applicant: Zadient Technologies SAS, 73800 Sainte-Hélène-du-Lac (FR)
(72) Inventor: CERAN, Kagan, 73190 Saint-Badolph (FR); RICHTER, Jan, 01277 Dresden (DE)
(74) Representative: Kehl, Ascherl, Liebhoff & Ettmayr Patentanwälte Partnerschaft mbB

(57) **Abstract**

The present invention refers to a furnace apparatus comprising a furnace unit, wherein the furnace unit comprises a furnace housing with an outer surface and an inner surface, at least one crucible unit, wherein the crucible unit is arranged inside the furnace housing, wherein the crucible unit comprises a crucible housing, wherein the crucible housing has an outer surface and an inner surface, wherein the inner surface at least partially defines a crucible volume, wherein a receiving space for receiving a source material is arranged or formed inside the crucible volume, wherein a seed holder unit for holding a defined seed wafer is arranged inside the crucible volume, wherein the furnace housing inner wall and the crucible housing outer wall define a furnace volume, at least one heating unit for heating the source material, wherein the receiving space for receiving the source material is at least in parts arranged below the seed holder unit, characterized in that a position adjustment unit for adjustment of the position of the seed holder unit during operation of the furnace apparatus is provided, wherein the position adjustment unit is configured to increase the distance between the seed holder unit and the receiving space by moving the seed holder unit away from the receiving space.

## Description

The present invention concerns at least a reactor or furnace apparatus for growing crystals according to claim 1 and preferably a method according to claim 19 for producing SiC material.

### Description of Related Art

Power electronics based on silicon carbide (SiC) wafers exhibit improved performance over those based on conventional silicon (Si) wafers, primarily due to the wider bandgap of SiC which allows it to operate at higher voltages, temperatures, and frequencies. With the worldwide transition to electric vehicles (EVs) gaining momentum, there is an increased interest in high performance SiC based power electronics, but SiC wafers remain considerably more expensive than Si wafers. Furthermore, commercial production of SiC wafers has only recently been standardized to 150 mm diameter, whereas commercial production of Si wafers has been standardized to 300 mm diameter for some time. Increased diameter is a major contributor to cost reduction in both the production of single crystals (from which wafers are cut), and the subsequent production of chips.

Currently, the prevailing method for commercial production of SiC single crystals is physical vapor transport (PVT). A conventional PVT furnace is formed in a cylindrical shape. It is composed of one quartz tube or two concentric water-cooled quartz tubes sealed by a water-cooled lower flange and a water-cooled upper flange, which define the furnace volume. The lower flange includes a furnace gas inlet and the upper flange incorporates a furnace vacuum outlet. The quartz tube or tubes are surrounded by an external induction coil.

Inside such a furnace volume there is thermal insulation, typically fabricated from graphite, and inside the thermal insulation there is a crucible, also typically fabricated from graphite. The crucible contains SiC source material, typically in powder form. A SiC single crystal grows from a SiC seed wafer which is attached to a seed holder typically fabricated from graphite. The seed holder in turn is attached to the crucible lid, typically fabricated from graphite.

The crucible unit and the crucible lid define the crucible volume.

The furnace volume and the crucible volume are at the same pressure because the crucible and the crucible lid are permeable to the process gases.

The crucible further incorporates a growth guide, typically fabricated from graphite, which is used to direct vapors toward the growing crystal and to tune the thermal field and vapor flow around the sides of the growing crystal.

The PVT furnace is operated by first purging the air inside the furnace volume and crucible volume with an inert gas such as argon. The pressure is reduced to a vacuum of between 0.1 to 50 Torr respectively 13,3322 to 6666,12 Pa and the temperature, as measured at the top of the crucible lid by a pyrometer along the pyrometer sightline, is increased to approximately 2,000 - 2,200°C using the induction coil. The PVT furnace is designed such that the temperature of the source material is typically several 100°C higher than the top of the crucible lid or filter lid.

At these temperatures and pressures the source material undergoes incongruent sublimation and releases mostly Si vapor, and some SiC₂ and Si₂C vapors, while becoming graphitized itself. The vapors migrate to the seed wafer by the process of thermally driven diffusion since the source material is maintained at a higher tempaerature that the seed wafer. Upon reaching the seed wafer, some of the SiC₂ and Si₂C vapors integrate into its crystal structure resulting in the growth of the crystal. Excess SiC₂ and Si₂C vapors pass between the growth guide and the crystal and form polycrystalline deposits on the sides of the seed holder, the underside of the crucible lid and the upper inner walls of the crucible.

By contrast, the Si vapor does not incorporate into the growing crystal but rather etches and permeates through all graphite components of the PVT furnace. When the source material has been largely consumed and crystal growth slows, the induction coil is turned off and the PVT furnace is cooled down. During repeated heating and cooling cycles, the Si vapor that has infiltrated the graphite components degrades the structural and thermal properties of these components. For example, the thermal conductivity of the insulation increases appreciably with the presence of infiltrated Si.

As a result, all graphite components of the PVT furnace have a relatively short service life and are typically replaced every few cycles, which contributes to high production costs. By contrast, the graphite components in a Czochralski (CZ) furnace used for production of Si single crystals typically have a service life of several hundred runs.

Permeability of the graphite crucible has become an accepted feature of SiC crystal growth by PVT, and operating methods have been adapted to this.

For example, doping gases such as nitrogen are typically introduced into the furnace volume through the furnace gas inlet and allowed to permeate into the crucible volume through the crucible to reach the crystal while Si vapor is permeating outward through the crucible into the furnace volume.

One of the main reasons the external induction coil is used instead of internal graphite resistive heating elements is that these heating elements would also quickly be degraded by the Si vapor. However, the induction coil has a significant limitation in that it causes a radial temperature gradient to form in the growing crystal because the sides of the crystal are closer to the induction coil and develop a higher temperature than the middle of the crystal. This temperature difference results in internal stresses in the crystal which in turn lead to defects. This phenomenon is accentuated as the diameter of the crystal is increased and is the primary reason why it is difficult to grow a large diameter crystal in a conventional PVT furnace.

In summary, uncontained Si vapor reduces the service life of graphite components in a conventional PVT furnace and also necessitate the use of an external induction coil which in turn limits the diameter of the crystal. A current state of the art conventional PVT furnace can grow SiC crystals with a diameter of typically only 150 mm whereas Si crystals are routinely grown to a diameter of 300 mm in a CZ furnace. Degradation by Si vapor of the graphite components in the PVT furnace changes their thermal properties and makes it difficult to maintain constant process conditions during a run and from one run to the next. Variability in process conditions results in a lower yield of crystals with acceptable levels of defects, also contributing to high production costs.

Numerous attempts have been made to improve the performance of the conventional PVT furnace. U.S. Pat. No. 20200199777 to Drachev et al. discloses a PVT furnace with solid source material positioned annularly between the crucible wall and an inner porous tube. A similar inner tube is proposed by Nishizawa et al. in New Crucible Design for SiC Single Crystal Growth by Sublimation, Mat. Res. Soc. Symp. Vol. 640, 2001 Materials Research Society. This inner tube essentially acts as an internal heater heated by the external induction coil and somewhat reduces the radial temperature gradient in the crystal.

U.S. Pat. No. 20190323145 to Zu et al. discloses a PVT furnace with an axial resistive heater positioned inside the furnace volume directly below the crucible. This axial resistive heater helps to create flatter radial isotherms but U.S. Pat. No. 20190323145 does not disclose any means of preventing Si vapor from escaping the crucible and degrading the axial resistive heater.

U.S. Pat. No. 20120285370 to Gupta et al. discloses a PVT furnace with a vapor capture trap disposed annularly around the crystal. The vapor capture trap is 3 - 20°C cooler than the crystal and may be filled with a vapor absorbing member. Sublimation vapors enter the vapor capture trap and form solid deposits therein. However, given that the crystal is typically at a temperature of approximately 2,000 - 2,200°C, primarily the SiC₂ and Si₂C sublimation vapors form deposits in the vapor capture trap whereas the Si sublimation vapor remains largely uncontained.

Wellman et al. in "Modified Physical Vapor Transport Growth of SiC-Control of Gas Phase Composition for Improved Process Condition", Mat. Sci. Forum, vols. 483-485 (2005) pp. 25-30, propose a gas pipe extending upward through the bottom of the crucible and through the source material to deliver gases into the crucible. This allows for tuning of the gas phase composition, particularly with respect to doping gases, resulting in improved crystal characteristics. However, injection of gases directly into the crucible volume slightly raises the pressure inside the crucible volume relative to the furnace volume and promotes permeation of gases, including Si vapor, through the crucible and into the surrounding insulation. Furthermore, the gas is delivered into the crucible at a point between the source material and the growing crystal, convectively disrupting the thermal diffusion driven mass flux of sublimation species to the crystal.

### Object of the present invention

Therefore, it is the object of the present invention to provide an improved reactor or furnace apparatus and an improved method for producing crystals, in particular SiC crystals. It is a further object of the present invention to provide a reactor or furnace apparatus and a method for producing crystals, in particular SiC crystals, in a more cost-effective manner. Thus, it is a further object of the present invention to provide a reactor or a furnace apparatus with increased lifetime and a method for producing crystals, in particular SiC crystals, that causes an increased lifetime of the reactor or furnace apparatus. It is another object of the present invention to provide a reactor or furnace apparatus and a method for producing crystals, in particular SiC crystals, that enables larger crystals, in particular longer crystals.

The before mentioned object is solved by a furnace apparatus according to claim 1. The furnace apparatus according to the present invention therefore is preferably a furnace apparatus for growing crystals, in particular for growing SiC crystals. Said furnace apparatus preferably comprises a furnace unit, wherein the furnace unit comprises a furnace housing with an outer surface and an inner surface, and at least one crucible unit, wherein the crucible unit is arranged inside the furnace housing, wherein the crucible unit comprises a crucible housing, wherein the crucible housing has an outer surface and an inner surface, wherein the inner surface at least partially defines a crucible volume, wherein a receiving space for receiving a source material is arranged or formed inside the crucible volume, wherein a seed holder unit for holding a defined seed wafer is arranged inside the crucible volume, wherein the furnace housing inner wall and the crucible housing outer wall define a furnace volume, and at least one heating unit for heating the source material, wherein the receiving space for receiving the source material is at least in parts arranged below the seed holder unit. The furnace apparatus preferably also comprises a position adjustment unit for adjustment of the position of the seed holder unit during operation of the furnace apparatus respectively such a position adjustment unit is provided. The position adjustment unit is highly preferably configured to increase the distance between the seed holder unit and the receiving space by moving the seed holder unit away from the receiving space. This solution is beneficial since a distance between a growth face of the growing SiC crystal and the source material can be kept in a defined range, since the already grown SiC crystal can be moved away from the source material. Thus, the conditions for growing the SiC crystal are preferably similar during the entire production run.

Further preferred embodiments are subject-matter of the following specification parts and/or the dependent claims.

The furnace apparatus comprises according to a preferred embodiment of the present invention a crucible gas flow unit, wherein the crucible gas flow unit comprises a crucible gas inlet for conducting gas into the crucible volume and a crucible gas outlet for removing gas from the crucible volume, wherein a gas flow path is defined between the crucible gas inlet and the crucible gas outlet, wherein a further gas inlet is provided for conducting gas into the crucible volume, wherein at least one modulating section for modulating a part of a gas flow path of gas insertable via the further gas inlet is formed for modulating growth of the SiC crystal. This embodiment is beneficial since on the one side gas provided via the crucible gas inlet assists in transporting vaporized source material to the growth face and on the other side gas provided via the further gas inlet causes shaping of the crystal during growing.

The modulating section of the gas flow path defines according to a preferred embodiment of the present invention a high velocity passage for increasing the gas flow velocity, wherein the modulating section is formed on one side at least partially by the seed holder unit and/or the seed wafer and/or the growing crystal. This embodiment is beneficial since the high velocity is generated in the relevant section of the gas flow path and therefore only affects the shape of the growing crystal. Furthermore, the high velocity passage can be easily provided since e.g. a small slit is sufficient to increase the velocity of the gas flow.

The modulating section is according to a preferred embodiment of the present invention formed on another side by a surface of a filter unit and/or a wall member of the crucible unit. This embodiment is beneficial since no additional "modulation section device" is required. Thus, the present components can be used to define the modulation section.

The further gas inlet is according to a preferred embodiment of the present invention arranged on a first side of the seed holder unit and the crucible gas inlet is arranged on a second side of the seed holder unit. This embodiment is beneficial since gas provided via the further gas inlet and gas provided via the crucible gas inlet cause different functions. Furthermore, both gases (the one introduced via the further gas inlet and the one introduced via the crucible gas inlet) are preferably removed from the crucible volume via the same crucible gas outlet.

A further-gas-sealing-unit is according to a preferred embodiment of the present invention provided for blocking a direct gas path from the further gas inlet to the crucible gas outlet. This embodiment is beneficial since the gas provided via the further gas inlet preferably passes through the modulation section and highly preferably also through the filter unit prior to the crucible gas outlet. Thus, the filter unit is according to a preferred embodiment of the present invention arranged inside the crucible volume between the crucible gas inlet tube and the crucible gas outlet tube for capturing at least Si₂C sublimation vapor, SiC₂ sublimation vapor and Si sublimation vapor, wherein the gas path from the further gas inlet extends through the filter unit to the crucible gas outlet.

The further-gas-sealing-unit comprises according to a preferred embodiment of the present invention a first side surface and a second side surface, wherein the first side surface and the first side of the seed holder define a gas insertion space for inserting gas via the further gas inlet. This embodiment is beneficial since the further-gas-sealing-unit thereby is part of a gas flow path section prior to the filter unit and another gas flow path section after the filter unit.

The position adjustment unit is according to a preferred embodiment of the present invention configured to move the seed holder unit in a defined direction for reducing the size of the space between the first side surface and the first side of the seed holder. This embodiment is beneficial since the crystal can be grown larger, in particular the length of the crystal can be at least extended according to the distance the seed holder unit is moved.

The position adjustment unit comprises according to a preferred embodiment of the present invention at least one repositioning element, wherein the repositioning element is attached to the seed holder unit or attachable to the seed holder unit and wherein the repositioning element extend through a sealed opening of the further-gas-sealing-unit. This embodiment is beneficial since the repositioning element or repositioning elements can be moved relatively to the further-gas-sealing-unit. Thus, the seed holder unit can be moved by means of a displacement of the repositioning element/s, wherein the further-gas-sealing-unit still avoids a direct gas flow from the further gas inlet to the crucible gas outlet.

The further-gas-sealing-unit is according to a preferred embodiment of the present invention coupled, in particular via one or multiple gaskets, to the filter unit. This embodiment is beneficial since leakage of gas provided via the further gas inlet to the gas-flow-path-section behind the filter unit can be prevented respectively reduced to defined fraction.

The position adjustment unit comprises according to a preferred embodiment of the present invention at least one repositioning element, wherein the repositioning element is attached to the seed holder unit or attachable to the seed holder unit. This embodiment is beneficial since the repositioning element/s and the seed holder unit can be provided as a single piece or as separated pieces.

The repositioning element is according to a preferred embodiment of the present invention a tube, wherein the tube forms the further gas inlet and wherein the seed holder unit comprises at least one hollow section or multiple hollow sections, wherein the tube and the hollow section or hollow sections are connected to guide gas through the tube and the hollow section or hollow sections to a surface between a first side of the seed holder unit and a second side of the seed holder unit. This embodiment is beneficial since repositioning and providing of gas can be carried out by the same means, in particular by one or multiple reposition element/s.

The seed holder unit comprises according to a preferred embodiment of the present invention at least one hollow section or multiple hollow sections, wherein the further gas inlet and the hollow section or hollow sections are connected to guide gas through the tube and the hollow section or hollow sections to a surface between a first side of the seed holder unit and a second side of the seed holder unit. The repositioning element and the further gas inlet preferably extend through sealed openings of the further-gas-sealing-unit. This embodiment is beneficial since the repositioning element and the further gas inlet are provided as separate elements. Thus, the reposition element and the further gas inlet can be made with low complexity and therefore highly durable.

The position adjustment unit for adjustment of the position of the seed holder unit during operation of the furnace apparatus comprises according to a preferred embodiment of the present invention an actuator, in particular a servo or step motor, wherein the motor is coupled to the at least one repositioning element, wherein the repositioning element is preferably a rod or cylinder. The motor is preferably an electro motor. This embodiment is beneficial since rods or cylinders as well as electro motors are highly reliable components which can be used to even hold and/or move very heavy weights.

The actuator is according to a preferred embodiment of the present invention arranged outside the crucible volume and preferably outside the furnace volume. This embodiment is beneficial since it is not necessary to provide a heat resistant actuator. Thus, the costs for a not-heat-resistant actuator are significant smaller compared to the costs for a heat-resistant actuator.

A control device for controlling operation of the actuator is according to a preferred embodiment of the present invention provided, wherein the control device controls the actuator in dependency of sensor signals, in particular sensor signals of a weight sensor, and/or in dependency of time. This embodiment is beneficial since a weight sensor provides signals in dependency of the accumulated mass. The weight sensor does not have to be installed within the crucible volume, since the weight signal can be sensed by means of a weight sensor attached to the repositioning element/s. As weight sensor also sensors can be understood which allow indirectly a measurement of the weight, like torque sensor for measuring torque of the actuator or power consumption of the actuator, etc.

According to a preferred embodiment of the present invention the furnace apparatus further comprises at least one leak prevention means for preventing leakage of gaseous silicon during operation from the inside of the crucible respectively crucible unit to a part of the furnace volume surrounding the crucible unit. This embodiment is beneficial since the drawbacks of leaking Si vapor are eliminated.

The leak prevention means is according to a further preferred embodiment of the present invention selected from a group of leak prevention means. The group of leak prevention means preferably comprises at least (a) a covering element for covering of surface parts and/or a density increasing element for increasing the density of a volume section of the crucible housing of the crucible unit, (b) a filter unit for capturing gaseous Si and/or (c) a pressure unit for setting up a first pressure inside the crucible unit and a second pressure inside the furnace but outside the crucible unit, wherein the second pressure is higher than the first pressure (d) gaskets arranged between housing parts of the crucible unit. This embodiment is beneficial since multiple features are provided to eliminate the drawbacks of leaking Si vapor. It is possible to provide such a furnace apparatus with one or multiple or all features of said group of leak prevention means. Thus, the present invention also provides solutions for varying needs, in particular for varying products, in particular crystals having different properties.

The leak prevention means reduces according to a further preferred embodiment of the present invention leakage from the crucible volume through the crucible housing to the furnace volume of sublimation vapors, in particular Si vapor, generated during one run, in particular by at least 50% (mass) or by at least 80% (mass) or by at least 90% (mass) or by more than 99% (mass) or by at least 99,9% (mass) (this means ninety-nine comma nine percent). This embodiment is beneficial since due to the significant reduction of leaking Si vapor furnace unit components like the crucible housing and the heating unit can be reused multiple times, in particular more than 10 times or more than 20 times or more than 50 times or more than 100 times. Thus, the crucible unit, respectively the crucible housing, respectively sections of the crucible unit, respectively sections of the crucible housing have a permeability of less than 10⁻² cm²/s or of less than 10⁻⁵cm²/s or of less than 10⁻¹⁰cm²/s, in particular in view of Si vapor.

The crucible housing comprises according to a further preferred embodiment of the present invention carbon, in particular at least 50% (mass) of the crucible housing are made of carbon and preferably at least 80% (mass) of the crucible housing are made of carbon and highly preferably at least 90% (mass) of the crucible housing are made of carbon or the crucible housing complete consists of carbon, in particular the crucible housing comprises at least 90% (mass) graphite or consists of graphite, to withstand temperatures respectively for withstanding temperatures above 2,000°C, in particular at least or up to 3,000°C or at least up to 3,000°C or up to 3,500°C or at least up to 3,500°C or up to 4,000°C or at least up to 4,000°C (this means four thousand degree Celsius). The crucible housing is preferably impermeable to silicon gas (Si vapor). This embodiment is beneficial as it prevents Si vapor from permeating through the crucible housing and damaging the crucible housing and components outside of the crucible housing. Additionally, or alternatively the crucible unit respectively the crucible housing structure or the crucible housing comprises glassy carbon coated graphite and/or solid glassy carbon and/or pyrocarbon coated graphite and/or tantalum carbide coated graphite and/or solid tantalum carbide, in particular solid CVD tantalum carbide.

The leak prevention means is according to a further preferred embodiment of the present invention a covering element for covering the surface of the housing, in particular the inner surface and/or the outer surface, or for covering surface parts of the housing, in particular surface parts of the inner surface of the housing and/or surface parts of the outer surface of the housing. This embodiment is beneficial since the covering element can be generated on a surface of the housing or can be attached to a surface of the housing in a reliable manner and this approach is more economical than making the housing entirely out of the covering material.

The covering element is according to a further preferred embodiment of the present invention a sealing element, wherein the sealing element is a coating. The coating preferably comprises a material or a material combination that reduces leakage from the crucible volume through the crucible housing to the furnace volume of sublimation vapors, in particular Si vapor, generated during one run, in particular by at least 50% (mass) or by at least 80% (mass) or by at least 90% (mass) or by more than 99% (mass) or by at least 99,9% (mass).

The coating preferably withstands temperatures above 2,000°C, in particular at least or up to 3,000°C or at least up to 3,000°C or up to 3,500°C or at least up to 3,500°C or up to 4,000°C or at least up to 4,000°C. This embodiment is beneficial the coating can reduce permeability of Si vapor through the crucible at the typical operating temperatures of the crucible. The coating highly preferably comprises a material or multiple materials selected from a group of materials at least comprising carbon, in particular pyrocarbon and glassy carbon. Thus, the crucible unit, in particular the crucible housing respectively the housing of the crucible unit is preferably coated with pyrocarbon and/or glassy carbon. The layer of pyrocarbon preferably has a thickness of more than or of up to 10µm, in particular of more than or of up to 20µm or of more than or of up to 50µm or of more than or of up to 100µm of more than or of up to 200µm of more than or of up to 500µm. The layer of glassy carbon preferably has a thickness of more than or of up to 10µm, in particular of more than or of up to 20µm or of more than or of up to 50µm or of more than or of up to 100µm of more than or of up to 200µm of more than or of up to 500µm.

The coating is generated according to a further preferred embodiment by chemical vapor deposition or wherein the coating is generated by painting, in particular of a precursor material, in particular phenol formaldehyde, and pyrolyzing after painting. This embodiment is beneficial since the coating can be generated in a reliable manner and this approach is more economical than making the housing entirely out of the covering material.

The leak prevention means is according to a further preferred embodiment of the present invention a density increasing element respectively a sealing element for increasing the density of a volume section of the crucible housing of the crucible unit, wherein the density increasing element is arranged or generated in the inner structure of the crucible housing, wherein the density increasing element is a sealing element, wherein the sealing element reduces leakage from the crucible volume through the crucible housing to the furnace volume of sublimation vapors, in particular Si vapor, generated during one run, in particular by at least 50% (mass) or by at least 80% (mass) or by at least 90% (mass) or by more than 99% (mass) or by at least 99,9% (mass). This embodiment is beneficial since the dimensions of the crucible unit remain the same respectively are not affected by the modification. The sealing element is preferably generated inside of the crucible housing by means of impregnation or deposition.

The leak prevention means is according to a further preferred embodiment of the present invention a filter unit for capturing gaseous Si. The filter unit comprises a filter body, wherein the filter body comprises a filter input surface respectively an input section for inputting gas comprising SiC species vapor, Si vapor, and process gases into the filter body and an output section respectively a filter output surface for outputting filtered process gas or gases, in particular doping and/or carrier gas/es. A filter element is arranged between the filter input surface and the filter output surface, wherein the filter element forms a trapping section for adsorbing and condensing SiC species vapor and in particular Si vapor. Thus, the filter material is preferably such that it causes Si vapors to be absorbed and condensed on a filter material surface. This embodiment is beneficial since SiC species vapors and Si vapors are trapped in a disposable component and do not coat and/or infiltrate other components of the furnace apparatus thus damaging and/or altering their properties such that their service lives are reduced. Thus, the amount of Si vapor which might leak is also significantly reduced. Most and preferably all of the Si vapors will be preferably trapped as a condensed liquid film on the internal surfaces of the filter. Additionally, or alternatively a zone in the upper section of the filter is defined in which the temperature is below the melting point of Si and the condensed vapors actually solidify. The Si vapors preferably do not solidify as particles, but preferably as a solid film on the internal surfaces of the filter. This film may be amorphous or polycrystalline. Excess Si2C and SiC2 vapors will preferably also permeate into the lower section of the filter and preferably precipitate there as solid polycrystalline deposits on the internal surfaces.

It is additionally or alternatively also possible that the filter element forms the filter body, in this case the overall structure of the filter element is sufficiently solid to allow positioning of the filter element inside the crucible volume, in particular to attach the seed holder unit to the filter element.

According to a further preferred embodiment of the present invention a filter unit is arranged outside the crucible volume, in particular in the direction of the gas flow path behind the crucible gas outlet tube or as part of the crucible gas outlet tube for capturing at least Si₂C sublimation vapor, SiC₂ sublimation vapor and Si sublimation vapor.

According to a further embodiment of the present invention additionally or alternatively a crucible gas flow unit is provided for causing gas flow along a gas flow path inside the crucible volume, wherein the gas flow unit comprises a crucible gas inlet tube for conducting gas into the crucible volume and a crucible gas outlet tube for removing gas conducted into the crucible volume via the crucible gas inlet tube from the crucible volume and additionally or alternatively a filter unit for capturing at least Si₂C sublimation vapor, SiC₂ sublimation vapor and Si sublimation vapor is provided, in particular inside the crucible volume, wherein the filter unit is highly preferably arranged between the crucible gas inlet tube and the crucible gas outlet tube.

According to a further embodiment of the present invention the gas flow path extends through the filter unit.

According to a further preferred embodiment of the present invention a filter unit is additionally or alternatively arranged outside the crucible volume, in particular in the direction of the gas flow path behind the crucible gas outlet tube or as part of the crucible gas outlet tube for capturing at least Si₂C sublimation vapor, SiC₂ sublimation vapor and Si sublimation vapor.

According to a further preferred embodiment of the present invention a filter unit for capturing sublimation vapors is provided, wherein the filter unit preferably comprises a filter body, wherein the filter body preferably comprises a filter input surface for inputting Si₂C vapor, SiC₂ vapor, Si vapor and one or multiple process gases, in particular argon and/or nitrogen, into the filter body and an output surface for outputting filtered process gases, wherein a filter element is preferably arranged between the filter input surface and the output surface, wherein the filter element forms a trapping section for adsorbing and condensing sublimation vapors, in particular Si vapor, wherein the filter unit preferably forms a filter outer surface, wherein the filter outer surface preferably comprises a filter outer surface covering element, wherein the filter outer surface covering element is preferably a sealing element, wherein the sealing element is preferably a filter coating, wherein the filter coating is preferably generated at the filter outer surface or attached to the filter outer surface or forms the filter outer surface.

The filter body is formed according to a further preferred embodiment of the present invention in an annular shape respectively forms an annular shape, wherein the filter outer surface preferably has a tubular shape and wherein the filter inner surface has a tubular shape, wherein the filter outer surface and the filter inner surface extend in vertical direction, in particular in an orthogonal angle to the horizontal axis. The filter unit comprises according to a further preferred embodiment of the present invention exactly one filter element, wherein the filter element is preferably fix coupled with the filter body or forms the filter body or wherein the filter element is preferably removably coupled with the filter body. The filter unit comprises according to a further preferred embodiment of the present invention a plurality of filter elements, in particular held by means of the filter body, and/or the filter unit is preferably formed by a plurality of filter sub-units, wherein each filter sub unit preferably comprises at least one filter element or forms one filter element. The filter unit forms according to a further preferred embodiment of the present invention a seed-holder-unit-attaching-section for attaching the seed holder unit and/or the filter unit preferably forms a crucible-lid-attaching-section for attaching a wall member of the crucible housing, in particular a crucible lid. The filter unit forms according to a further preferred embodiment of the present invention multiple filter sections for capturing sublimation vapors, wherein a first filter section is preferably formed to capture Si vapor and wherein a second filter section is preferably formed to capture Si₂C vapor and/or SiC₂ vapor, wherein the first filter section and the second filter section differ in at least one and preferably in multiple properties selected from the list of properties: mass, height, density, surface area, material, thermal stability, volume, geometry and/or capacity. The distance between the filter outer surface and the filter inner surface differs according to a further preferred embodiment of the present invention on at least multiple different vertical positions between the filter input surface and the filter output surface or wherein the distance between the filter outer surface and the filter inner surface is preferably at least constant on the majority of vertical positions between the filter input surface and the filter output surface.

The filter element forms respectively defines according to a preferred embodiment of the present invention a gas flow path from the filter input surface to the output surface. The filter element has a height S1 and wherein the gas flow path respectively the filter-unit-gas-flow-path through the filter element has a length S2, wherein S2 is preferably at least 10 times longer compared to S1, in particular S2 is at least 100 times longer compared to S1 or S2 is at least or up to 1,000 times longer compared to S1 or S2 is at least or up to 10,000 times longer compared to S1. This embodiment is beneficial since this torturous path through the filter unit allows for a high incidence of contact between the sublimation vapors and the high internal surface area of the filter and this high internal surface has a capacity to absorb or to trap more than or up to 50% (mass), in particular more than or up to 50% (mass) or more than or up to 70% (mass) or more than or up to 90% (mass) or more than or up to 95% (mass) more than or up to 99% (mass), of Si vapor generated by vaporization of the source material, in particular of the source material used respectively required during one run. "One run" preferably defines the generation respectively production of one crystal, in particular SiC crystal or SiC ingot or SiC boule, in particular the entire process between start and end of SiC crystal growth process, wherein during said process a SiC crystal preferably growth on a seed wafer, wherein the SiC crystal highly preferably has a mass of more than 1kg or more than 5kg or more than 10kg or more than 50kg or more than 100kg at the end of the crystal growth process respectively at the end of the run.

The filter unit forms according to a further preferred embodiment of the present invention a SiC trapping section for adsorbing and condensing SiC species vapor and a Si trapping section for absorbing and condensing Si species vapor. The SiC trapping section is preferably formed and/or arranged in such a manner to adsorb and condense more SiC (mass) compared to Si (mass) and/or the Si trapping section is preferably formed and/or arranged in such a manner to adsorb and condense more Si (mass) compared to SiC (mass). The SiC trapping section is preferably arranged in a first temperature region and the Si trapping section is preferably arranged in a second temperature region, wherein the average temperature during operation of the furnace apparatus in the second temperature region is higher compared to the average temperature in the first temperature region, in particular at least 5°C or preferably at least 10°C and highly preferably at least or up to 30°C and most preferably at least or up to 50°C higher. The filter unit is according to a further preferred embodiment of the present invention arranged between a first part of the housing of the crucible unit and a second part, in particular a crucible lid or filter lid, of the housing of the crucible unit. At least 50% (vol.), in particular at least 80% (vol.) or at least 90% (vol.), of the first part of the housing of the crucible unit is arranged in a vertical direction below the seed holder unit, wherein a first crucible volume is present between the first part of the housing of the crucible unit and the seed holder, wherein the first crucible volume can be operated such that at least 80% or preferably 90% or more preferably 100% of the first crucible volume is above the condensation temperature T_{c} of silicon at the prevailing pressure. Alternatively, at least 50% (vol.), in particular at least 80% (vol.) or 90% (vol.), of the second part of the housing of the crucible unit is arranged in vertical direction above the seed holder unit. A second crucible volume or filter element is preferably present between the second part of the housing of the crucible unit and the seed holder. At least 60%, or preferably 80%, or more preferably 90% of the filter element is below the condensation temperature T_{c}. Thus, the thermal conditions within the filter element of the filter unit enable condensation of Si vapor. Thus, the filter element can condense respectively trap Si in a very effective manner.

The filter unit is according to a further preferred embodiment of the present invention arranged between a first wall part of the first part of the housing and a further wall part of the second part of the housing, wherein the filter body forms a filter outer surface, wherein the filter outer surface connects the first wall part of the first part of the housing and the further wall part of the second part of the housing, wherein the filter outer surface forms a portion of the outer surface of crucible unit. This embodiment is beneficial since a separate and disposable filter unit can be used yet forms an integral part of the crucible unit during operation and allows the crucible unit to have a fully sealed crucible housing.

The filter unit forms according to a further preferred embodiment of the present invention an overlapping region, wherein the overlapping region overlaps in vertical direction at least partially and preferably mainly and most preferably entirely a backside surface of the seed holder unit. The overlapping region preferably comprises or forms a heat dissipating means for dissipating heat radiated via the backside surface of the seed holder unit.

The filter outer surface comprises according to a further preferred embodiment of the present invention a filter surface covering element. The filter surface covering element is preferably a sealing element, wherein the sealing element is preferably a coating, wherein the coating is preferably generated at the filter surface or attached to the filter surface or forms the filter surface. The coating preferably comprises a material or a material combination that reduces leakage from the crucible volume through the crucible housing to the furnace volume of sublimation vapors, in particular Si vapor, generated during one run, in particular by at least 50% (mass) or by at least 80% (mass) or by at least 90% (mass) or by more than 99% (mass) or by at least 99,9% (mass), wherein the coating withstands temperatures above 2.000°C, in particular at least or up to 3,000°C or at least up to 3,000°C or up to 3,500°C or at least up to 3,500°C or up to 4,000°C or at least up to 4,000°C.

The coating comprises a material or multiple materials selected from a group of materials at least comprising carbon, in particular pyrocarbon and glassy carbon. Thus, the coating is preferably a glassy carbon coating or a pyrocarbon coating or a glassy carbon undercoating and pyrocarbon top coating or a pyrocarbon undercoating and a glassy carbon top coating. Thus, the filter unit, in particular the outer surface of the filter unit is preferably coated with pyrocarbon and/or glassy carbon. The layer of pyrocarbon preferably has a thickness of more than or of up to 10µm, in particular of more than or of up to 20µm or of more than or of up to 50µm or of more than or of up to 100µm of more than or of up to 200µm of more than or of up to 500µm. The layer of glassy carbon preferably has a thickness of more than or of up to 10µm, in particular of more than or of up to 20µm or of more than or of up to 50µm or of more than or of up to 100µm of more than or of up to 200µm of more than or of up to 500µm.

The filter body forms according to a further preferred embodiment of the present invention a filter inner surface. The filter inner surface respectively inner filter surface is preferably arranged in coaxial manner with respect to the filter outer surface. The filter body is preferably formed in a ring-shaped or annular manner. The filter outer surface has preferably a cylindrical shape and/or wherein the filter inner surface has preferably a cylindrical shape. The filter outer surface and the filter inner surface extend in a vertical direction. This embodiment is beneficial since the semiconductor industry is standardized on processing circular SiC wafers and the associated SiC crystals from which they are sliced are grown in a cylindrical shape in cylindrical crucibles. The growing crystal needs to radiate heat from its backside to the furnace housing with no heat absorbing material in between so that it can be at a lower temperature than the subliming source material and thus achieve a mass flux of sublimation species to its growth face. Thus, an annularly shaped filter body is beneficial in that it can attach onto a crucible near its outer surface and a seed holder near its inner surface while still allowing the crystal backside to radiate heat directly to the furnace housing.

The filter inner surface comprises according to a further preferred embodiment of the present invention a further filter inner surface covering element. The further filter inner surface covering element is preferably a sealing element, wherein the sealing element is preferably a coating respectively a filter-coating. The coating is preferably generated at the filter surface or attached to the filter surface or forms the filter surface. The coating preferably comprises a material or a material combination that reduces leakage respectively for reducing leakage from the crucible volume through the crucible housing to the furnace volume of sublimation vapors, in particular Si vapor, generated during one run, in particular by at least 50% (mass) or by at least 80% (mass) or by at least 90% (mass) or by more than 99% (mass) or by at least 99,9% (mass).

The coating preferably withstands temperatures above 2,000°C, in particular above 2200°C or above 2,000°C, in particular at least or up to 3,000°C or at least up to 3,000°C or up to 3,500°C or at least up to 3,500°C or up to 4,000°C or at least up to 4,000°C. The coating preferably comprises a material or multiple materials selected from a group of materials at least comprising carbon, in particular pyrocarbon and glassy carbon. Thus, the filter unit, in particular the inner surface of the filter unit is preferably coated with pyrocarbon and/or glassy carbon. The layer of pyrocarbon preferably has a thickness of more than or of up to 10µm, in particular of more than or of up to 20µm or of more than or of up to 50µm or of more than or of up to 100µm of more than or of up to 200µm of more than or of up to 500µm. The layer of glassy carbon preferably has a thickness of more than or of up to 10µm, in particular of more than or of up to 20µm or of more than or of up to 50µm or of more than or of up to 100µm of more than or of up to 200µm of more than or of up to 500µm.

The filter element comprises according to a further preferred embodiment of the present invention a filter element member, wherein the filter element member comprises filter particles and a binder. The filter particles comprise carbon or consist of carbon, wherein the binder holds the filter particles in fixed relative positions to each other. The filter particles withstand temperatures above 2,000°C, in particular above 2,000°C, in particular at least or up to 3,000°C or at least up to 3,000°C or up to 3,500°C or at least up to 3,500°C or up to 4,000°C or at least up to 4,000°C. The binder withstands temperatures above 2,000°C, in particular 2,000°C, in particular at least or up to 3,000°C or at least up to 3,000°C or up to 3,500°C or at least up to 3,500°C or up to 4,000°C or at least up to 4,000°C. This embodiment is beneficial since a filter unit is provided which withstands the conditions inside a crucible unit during operation of the furnace apparatus. Furthermore, due to the combination of filter particles and binder a surface is formed which is significantly larger compared to the outer surface of the filter unit, in particular up to or at least 10 times larger or up to or at least 100 times larger or up to or at least 1,000 times larger or up to or at least 10,000 times larger. This embodiment is further beneficial since the higher the internal surface area of the filter is the more sublimation species can be adsorbed and/or condensed in the filter and the filter unit has a capacity to absorb or to gather more than or up to 50% (mass), in particular more than or up to 50% (mass) or more than or up to 70% (mass) or more than or up to 90% (mass) or more than or up to 95% (mass) more than or up to 99% (mass), of Si vapor generated by vaporization of the source material, in particular of the source material used respectively required during one run.

The binder comprises according to a further preferred embodiment of the present invention starch or wherein the binder consists of modified starch and/or glassy carbon precursors such as phenol formaldehyde and/or furfuryl alcohol and/or polymers thereof.

This embodiment is beneficial, since such a binder withstands the high operating temperatures of the filter unit, in particular temperatures above 2,000°C, in particular at least or up to 3,000°C or at least up to 3,000°C or up to 3,500°C or at least up to 3,500°C or up to 4,000°C or at least up to 4,000°C. The binder withstands temperatures above 2,000°C, in particular 2,000°C, in particular at least or up to 3,000°C or at least up to 3,000°C or up to 3,500°C or at least up to 3,500°C or up to 4,000°C or at least up to 4,000°C.

The gas inlet is according to a further preferred embodiment of the present invention arranged between the receiving space and the seed holder unit, wherein the gas inlet is preferably in vertical direction arranged closer to the receiving space compared to the seed holder unit, in particular the vertical distance between the seed holder unit and the gas inlet is preferably more than 2 times the vertical distance between the receiving space and the gas inlet, in particular more than 5 times the vertical distance between the receiving space and the gas inlet or more than 8 times the vertical distance between the receiving space and the gas inlet or more than 10 times the vertical distance between the receiving space and the gas inlet or more than 20 times the vertical distance between the receiving space and the gas inlet. This embodiment is beneficial since a gas flow can be established which allows the inputted gas or gases to mix completely with the vaporizing source material and the resulting mixture to arrive at the seed wafer respective at the growth front of the crystal at a homogenous composition.

The gas inlet is covered according to a further preferred embodiment of the present invention by a gas guiding member respectively a gas distribution member. The gas distribution member preferably extends parallel to a bottom surface of the crucible unit, in particular the inner bottom surface of the crucible unit. Additionally, or alternatively the gas distribution member extends in a horizontal plane. This embodiment is beneficial since the introduced gas can be distributed in a homogeneous manner to the annular receiving space and therefore to the source material present in the receiving space or to the vaporized source material which flows out of the receiving space. The vaporized source material moves by thermally driven diffusion. Additionally, or alternatively the vaporized source material moves by convection from gas, in particular Ar and/or N₂, injected.

The gas distribution member is arranged according to a further preferred embodiment of the present invention in a defined distance to the bottom surface of the crucible unit, in particular the inner bottom surface of the crucible unit. The defined distance in vertical direction between the lower surface of the gas distribution member and the bottom surface of the crucible unit is preferably less than 0,5x vertical distance between the receiving space and the gas inlet (this means: less than half the vertical distance between the receiving space and gas inlet) or less than 0,3x vertical distance between the receiving space and the gas inlet or less than 0,1x vertical distance between the receiving space and the gas inlet or less than 0,05x vertical distance between the receiving space and the gas inlet.

The gas distribution member is according to a further preferred embodiment of the present invention a gas guiding plate. The gas guiding plate preferably forms a lower surface and an upper surface. The lower surface and the upper surface preferably extend at least sectionally in parallel to each other. The distance between the lower surface and the upper surface is preferably less than 0,5x distance between the receiving space and the gas inlet or less than 0,3x distance between the receiving space and the gas inlet or less than 0,1x distance between the receiving space and the gas inlet or less than 0,05x distance between the receiving space and the gas inlet. This embodiment is beneficial since a thin gas distribution plate can be used. This is beneficial since the gas distribution plate does not incorporate a significant amount of material which would alter the thermal field inside the crucible volume. Furthermore, the gas distribution plate does not affect heat radiated from a bottom section covered by the gas distribution plate.

In another preferred embodiment of the present invention, the gas inlet is positioned at the inner bottom surface of the crucible. A source material plate is positioned above the inner bottom surface of the crucible such that there is a plate gap between the bottom surface of the source material plate and the inner bottom surface of the crucible. This plate gap allows any incoming gas from the gas inlet to spread evenly underneath the source material plate. The upper surface of the source material plate defines the bottom of the source material receiving area and supports the weight of the source material. The source material plate has porous sections or holes to allow gas to pass through. Gas travels through the crucible unit according to the following path:
1. In through the gas inlet
2. through the gap
3. through the source material plate
4. through the source material
5. around the growing crystal
6. through the gap between the seed holder and the growth guide
7. through the filter unit
8. out the crucible vacuum outlet tube
   additionally or alternatively another gas or a further gas travels through:
9. a modulation section
10. through the filter unit
11. out the crucible vacuum outlet tube.

In a typical PVT crucible with no gas inlet and outlet and hence no active gas flow, the mass flux of the sublimation species is driven primarily by thermal diffusion. Sublimation species travel in a direction away from areas of high temperature toward areas of lower temperature. The greater the temperature difference, the faster the species diffuse. If the typical PVT system was a perfectly closed system where no sublimation species were escaping the crucible volume and the source material was the coldest area, the partial pressures of the sublimation species would be reached and no further sublimation would occur. As it is, the typical PVT crucible is made of permeable graphite and the coldest areas are the seed holder and lid. Consequently, substantial sublimation of the source material is achieved since Si vapor escapes the crucible volume through the permeable graphite walls and since Si₂C and SiC₂ vapors condense on the seed and lid. Thus, the typical PVT system can be described as a partially closed system.

By contrast, the crucible unit of the present invention can be described as a partially open system. A carrier gas such as argon is actively pumped through the crucible volume by means of the gas inlet tube, the highly permeable filter, and the vacuum outlet tube. This creates a convective force which augments the thermal diffusion force and substantially increases the sublimation rate of the source material, the mass flux of sublimation species to the crystal and the growth rate of the crystal.

In a further embodiment of the present invention the source material is heated to a higher temperature than that of the typical PVT furnace. For example, it is heated to 2,500°C compared to approximately 2,000°C for the typical PVT furnace. At this higher temperature, more of the source material sublimes as Si₂C and SiC₂ and less as Si. This has the dual benefit of increasing the mass flux of SiC species to the crystal thus increasing growth rate and reducing the amount of Si vapors that need to be contained and absorbed and condensed by the filter unit.

However, operating the crucible unit at higher than typical temperatures and with active carrier gas flow increases the risk of particulates from the crucible components and the source material being entrained into the gas flow and attaching to the growing crystal where they can form defects such as micropipes. To counter this possibility, the crucible components of the present invention can preferably be made from materials that are less likely to release particulates including graphite coated with tantalum carbide, or pyrocarbon and/or glassy carbon, or solid glassy carbon or solid tantalum carbide. Likewise, the source material of the present invention can preferably be in a granular format rather than a powder format, with granules of average diameter of at least 1 mm which have been washed to remove any surface fines.

The leak prevention means is according to a further preferred embodiment of the present invention a pressure unit for setting up a first pressure inside the crucible unit and a second pressure inside the furnace but outside the crucible unit, wherein the second pressure is higher than the first pressure and wherein the second pressure is below 200 Torr respectively 26664,5 Pa, in particular below 100 Torr respectively 13332,2 Pa or below 50 Torr respectively 6666,12 Pa, in particular between 0,01 Torr respectively 1,333224 Pa and 30 Torr respectively 3999,67 Pa.. The second pressure is preferably up to 10 Torr respectively 1333,22 Pa or up to 20 Torr respectively 2666,45 Pa or up to 50 Torr respectively 6666,12 Pa or up to 100 Torr respectively 13332,2 Pa or up to 180 Torr respectively 23998 Pa higher compared to the first pressure. This embodiment is beneficial since due to the higher pressure around the crucible unit leakage of Si vapor is prevented.

A pipe system is according to a further preferred embodiment of the present invention part of the furnace apparatus. The pipe system preferably comprises a first pipe respectively a crucible pipe respectively a crucible gas outlet tube connecting the crucible volume with a vacuum unit and a second pipe respectively a furnace pipe connecting the part of the furnace which surrounds the crucible unit to the vacuum unit. The vacuum unit preferably comprises a control element for controlling the pressure inside the crucible volume and the pressure in the part of the furnace which surrounds the crucible unit. The vacuum unit preferably reduces pressure inside the crucible volume via the crucible pipe respectively the crucible gas outlet tube or inside the part of the furnace which surrounds the crucible unit via the furnace pipe in case the control element determines that the pressure inside the crucible volume is above a first threshold and/or in case the control element determines that the pressure inside the part of the furnace which surrounds the crucible unit is above a second threshold. This embodiment is beneficial since the pressure difference between the pressure inside the crucible volume and the pressure inside the furnace and around the crucible volume can be controlled. Thus, the control element can be configured to control pressure inside the part of the furnace which surrounds the crucible unit and/or inside the crucible volume.

According to a further preferred embodiment of the present invention a pressure unit for setting up a crucible volume pressure inside the crucible volume and a furnace volume pressure inside the furnace volume but outside the crucible housing is provided. During the growth phase of the run when the source material is subliming and the crystal is growing, the crucible volume pressure is preferably below 500 Torr respectively 66661,2 Pa, or preferably below 350 Torr respectively 46662,8 Pa, or more preferably below 300 Torr respectively 39996,7 Pa, in particular in a range between 20Torr respectively 2666,45 Pa and 300Torr respectively 39996,7 Pa or between 30 Torr respectively 3999,67 Pa and 250Torr respectively 33330,6 Pa, and wherein during this time, the furnace volume pressure is higher than the crucible volume pressure, wherein the furnace volume pressure is preferably more than 1 Torr respectively 133,322 Pa or highly preferably more than 5 Torr respectively 666,612 Pa or most preferably more than 10 Torr respectively 1333,22 Pa or more than 20 Torr respectively 2666,45 Pa higher compared to the crucible volume pressure.

Thus, the pressure unit is preferably configured to cause crucible volume pressure below 66661,2Pa or in a range between 2666,45 Pa and 39996,7 Pa, and to cause furnace volume pressure of more than 133,322 Pa or highly preferably more than 666,612 Pa higher compared to the crucible volume pressure.

The furnace apparatus comprises according to a further preferred embodiment of the present invention two or more than two leak prevention means of the group of leak prevention means. This embodiment is beneficial since multiple leak prevention means can be more effective than one. The furnace apparatus comprises at least the covering element and/or the density increasing element and the filter unit for capturing gaseous Si or since the furnace apparatus comprises at least the covering element and/or the density increasing element and the pressure unit for setting up the first pressure inside the crucible unit and the second pressure inside the furnace but outside the crucible unit or since the furnace apparatus comprises at least the pressure unit for setting up the first pressure inside the crucible unit and the second pressure inside the furnace but outside the crucible unit and the filter unit.

However, it is also possible that the furnace apparatus comprises at least the covering element and/or the density increasing element and the filter unit for capturing gaseous Si and the pressure unit for setting up the first pressure inside the crucible unit and the second pressure inside the furnace but outside the crucible unit

This embodiment is beneficial since leakage of Si vapor can be prevented in several ways, thus it is possible to set up the furnace apparatus according to the present invention to fulfill requirements in dependency of different needs.

The heating unit comprises according to a further preferred embodiment of the present invention at least one, in particular horizontal, heating element, wherein the heating element is arranged in vertical direction below the receiving space. Thus, the heating element preferably underlaps at least partially and preferably mainly or completely the receiving space. This embodiment is beneficial since the receiving space and the part of the crucible volume or crucible housing surrounded by the receiving space can be heated from below the crucible volume thus creating an axial thermal gradient within the crucible volume. This is beneficial since the height of the receiving space and the height of the part of the crucible volume or crucible housing surrounded by the receiving space are the same in case of a seed wafer having a small diameter or in case of a larger diameter. Thus, the source material can be heated in a homogeneous manner. The heating unit preferably also comprises at least one further, in particular vertical, heating element, wherein the further heating element is preferably arranged around the crucible unit, in particular around a side wall of the crucible unit. The heating element and/or the further heating element is preferably arranged inside the furnace but outside the crucible unit, in particular outside the crucible volume.

The receiving space is formed according to a further preferred embodiment of the present invention in a wall portion of the crucible unit or arranged on a wall or bottom section inside the crucible unit. The receiving space preferably extends around a central axis, wherein the central axis preferably extends coaxially to a central axis of the seed holder unit. The receiving space is preferably arranged from the center axis or in a defined distance from the central axis.

A gas pipe or gas conducting means for introducing gas into the crucible unit is provided according to a further preferred embodiment of the present invention. The gas pipe or gas conducting means respectively a section of the gas pipe or gas conducting means or a gas inlet attached to the gas pipe or gas conducting means or a part of the gas pipe or gas conducting means is at least partially and preferably mainly or completely surrounded by the receiving space. The gas pipe or gas conducting means preferably extends at least partially in the direction of the central axis. The gas pipe or gas conducting means preferably enters the crucible volume through a bottom part of the crucible unit respectively through a bottom part of the crucible housing of the crucible unit. This embodiment is beneficial since via one gas pipe or gas conducting means gas can be provided to the crucible volume such that convective gas flow can be established in the same direction as thermal diffusion gas flow. Furthermore, since the gas inlet is surrounded by the receiving space the gas introduced via the gas inlet can be distributed to the different parts of the receiving space, in particular homogeneously. Thus, a mixture of introduced gas and vaporized source material can be generated, in particular in a homogeneously manner.

The receiving space has according to a further preferred embodiment of the present invention an annular shape. The receiving space is preferably shaped or formed as a trench, in particular a circular trench, or by multiple recesses, in particular circular recesses. Said multiple recesses are preferably arranged along a predefined contour, wherein the predefined contour is preferably formed circular. This embodiment is beneficial since the seed wafer preferably has a circular shape. Thus, the vaporized source material approaches the growth face of the seed wafer or a growth surface of the growing crystal in a proportional manner.

The defined distance between the receiving space and the central axis is according to a further preferred embodiment of the present invention up to 30% or up to 20% or up to 10 % or up to 5% or up to 1% shorter than the radius of the defined seed wafer. Alternatively, the defined distance between the receiving space and the central axis is up to 1% or up to 5% or up to 10 % or up to 20% or up to 30% longer than the radius of the defined seed wafer. Alternatively, the defined distance between the receiving space and the central axis matches with the radius of the defined seed wafer. This embodiment is beneficial since it further supports homogeneous distribution of vaporized source material over the growth face of the seed wafer or over a growth surface of the growing crystal.

In another preferred embodiment of the present invention, the defined distance between the receiving space and the center axis is zero and thus the source material fills the entire bottom of the crucible.

The receiving space surrounds according to a further preferred embodiment of the present invention a bottom section of the housing respectively surrounds a section above the bottom of the housing. The bottom section is a solid material section. The solid material section respectively a crucible solid bottom section preferably has a height (in vertical direction) respectively a wall thickness which is higher than 0,3 x the smallest distance between the receiving space and the central axis or which is higher than 0,5 x the smallest distance between the receiving space and the central axis or 0,7 x the smallest distance between the receiving space and the central axis or which is higher than 0,9 x the smallest distance between the receiving space and the central axis or 1,1 x the smallest distance between the receiving space and the central axis or which is higher than 1,5 x the smallest distance between the receiving space and the central axis. This embodiment is beneficial since the bottom section respectively the surrounded bottom section can be heated by the heating unit. In case the bottom section is heated it heats the space between the seed wafer and also the seed wafer. Since the bottom section is preferably a solid block of material respectively a crucible solid bottom section heating of the space between the seed wafer and the bottom section and heating the seed wafer or the growth face of the growing crystal happens in a homogeneous manner. The bottom section preferably has an outer surface section which is preferably a surface section of the crucible housing and an inner surface section, wherein the inner surface section is preferably parallel to the outer surface section. This is beneficial since the bottom section can be homogeneously heated. The inner surface section of the bottom section is preferably a flat surface, wherein the flat surface is preferably arranged in horizontal plane. The inner surface section is preferably arranged in parallel to the surface of the seed wafer. This embodiment is beneficial since the space between the seed wafer and the bottom section and the seed wafer and/or the growth face of the growing crystal can be heated in a homogeneous manner.

Thus, the bottom section comprises an inner surface, wherein the inner surface of the bottom section is arranged inside the crucible volume and preferably in parallel to the seed holder unit. The center of the inner surface and the center of the seed holder unit are preferably arranged on the same vertical axis, wherein a distance between the inner surface of the bottom section is preferably arranged in a predefined distance to the seed holder unit. The distance is preferably higher than 0,5x the smallest distance between the receiving space and the central axis or higher than 0,7x the smallest distance between the receiving space and the central axis or higher than 0,8x the smallest distance between the receiving space and the central axis or higher than 1x the smallest distance between the receiving space and the central axis or higher than 1,2x the smallest distance between the receiving space and the central axis or higher than 1,5x the smallest distance between the receiving space and the central axis or higher than 2x the smallest distance between the receiving space and the central axis or higher than 2,5x the smallest distance between the receiving space and the central axis. This embodiment is beneficial since large (wide and/or long) crystals can be grown.

The filter unit is arranged in vertical direction above the receiving space. This embodiment is beneficial since the vaporized source material and/or the introduced gas flows from a lower crucible section to an upper crucible section, thus the filter unit is preferably arranged in the gas flow path.

The filter unit and the receiving space are according to a further preferred embodiment of the present invention preferably arranged coaxial. This embodiment is beneficial since vaporized source material and/or introduced gas, respectively a mixture of vaporized source material and introduced gas, can pass the side wall, which is preferably of a cylinder shape, in a homogeneous manner. Thus, aggregations of vaporized source material and/or introduced gas can be prevented. This is beneficial since it allows the crystal to grow in a homogeneous manner. Homogeneous growth preferably means that the growth speed is on all surface parts of the growth face of the crystal are within a defined range and/or the accumulation of defects and/or doping is uniformly distributed, wherein the term "uniformly distributed" defines an admissible ranged of deviations.

An outer diameter of the filter unit corresponds according to a further preferred embodiment of the present invention to an outer diameter of the receiving space and/or wherein an inner diameter of the filter unit preferably corresponds to an inner diameter of the receiving space. This embodiment is beneficial since the shape of the housing does not cause significant complexity and therefore allows cost effective manufacturing. The outer diameter of the filter unit is preferably at least or up to 1,05x larger compared to the outer diameter of the receiving space or wherein the outer diameter of the filter unit is preferably at least or up to 1,1x larger compared to the outer diameter of the receiving space or wherein the outer diameter of the filter unit is preferably at least or up to 1,3x larger compared to the outer diameter of the receiving space or wherein the outer diameter of the filter unit is preferably at least or up to 1,5x larger compared to the outer diameter of the receiving space. Alternatively the outer diameter of the receiving space is preferably at least or up to 1,05x larger compared to the outer diameter of the filter unit or wherein the outer diameter of the receiving space is preferably at least or up to 1,1 x larger compared to the outer diameter of the filter unit or wherein the outer diameter of the receiving space is preferably at least or up to 1,3x larger compared to the outer diameter of the filter unit or wherein the outer diameter of the receiving space is preferably at least or up to 1,5x larger compared to the outer diameter of the filter unit. Additionally or alternatively the inner diameter of the receiving space is preferably at least or up to 1,05x larger compared to the inner diameter of the filter unit or wherein the inner diameter of the receiving space is preferably at least or up to 1,1x larger compared to the inner diameter of the filter unit or wherein the inner diameter of the receiving space is preferably at least or up to 1,3x larger compared to the inner diameter of the filter unit or wherein the inner diameter of the receiving space is preferably at least or up to 1,5x larger compared to the inner diameter of the filter unit. Alternatively the inner diameter of the filter unit is preferably at least or up to 1,05x larger compared to the inner diameter of the receiving space or wherein the inner diameter of the filter unit is preferably at least or up to 1,1x larger compared to the inner diameter of the receiving space or wherein the inner diameter of the filter unit is preferably at least or up to 1,3x larger compared to the inner diameter of the receiving space or wherein the inner diameter of the filter unit is preferably at least or up to 1,5x larger compared to the inner diameter of the receiving space.

A growth guide element is arranged respectively provided according to a further preferred embodiment of the present invention in vertical direction above the receiving space to guide vaporized source material and/or introduced gas into a space between the seed holder unit and the inner bottom surface of the crucible unit. This embodiment is beneficial since the growth guide element enhances crystal growth efficiency, quality, and shape. On the one hand the growth guide element guides the vaporized source material to the seed wafer respectively the growing crystal to increase the amount of monocrystal grown relative to the amount of source material vaporized by minimizing parasitic polycrystalline deposition on the upper areas of the crucible unit. On the other hand, the growth guide element creates a zone of no deposition which prevents the polycrystalline growth from contacting the monocrystalline growth and causing defects in the latter. In some cases, the growth guide can also be used to achieve diameter expansion of the crystal by affecting its growth direction. The growth guide element comprises according to a further preferred embodiment of the present invention a first wall section respectively a growth guide first section and a second wall section respectively a growth guide second section. The growth guide first section is preferably shaped to match with a corresponding wall section of the crucible housing. Matching preferably means in this context that the wall section of the crucible housing and the growth guide element are preferably coupled by means of a form closure and/or press fit connection. The growth guide second section is preferably formed to manipulate the shape of a growing crystal. The growth guide first section and the growth guide second section are according to a further preferred embodiment of the present invention arranged coaxially. The growth guide first section is arranged in a first diameter to the center axis and wherein the growth guide second section is arranged in a second diameter to the center axis, wherein the first diameter is larger compared to the second diameter. The growth guide first section and the growth guide second section are connected with each other by means of a third wall section respectively a growth guide third section, wherein the growth guide third section at least partially extends in horizonal direction. The growth guide first section and the growth guide third section form an arc shaped section respectively a growth guide fourth section and/or wherein the growth guide second section and the growth guide third section are arranged in an angle between 60° and 120°, in particular in an angle between 70° and 110°, in particular in an angle of 90°. The growth guide fourth section can have e.g. a convex or concave or conical shape. The first wall section, the growth guide second section and the growth guide third section are preferably integral parts of the growth guide. The growth guide preferably comprises graphite. This embodiment is beneficial since the growth guide element has a simple but effective shape. Thus, the growth guide element can be manufactured in a cost-effective manner.

The outer diameter of the filter unit is according to a further preferred embodiment of the present invention at least or up to 1,05x larger compared to the first diameter of the growth guide element or wherein the outer diameter of the filter unit is preferably at least or up to 1,1x larger compared to the first diameter of the growth guide or wherein the outer diameter of the filter unit is preferably at least or up to 1,3x larger compared to the first diameter of the growth guide or wherein the outer diameter of the filter unit is preferably at least or up to 1,5x larger compared to the first diameter of the growth guide and/or wherein the second diameter of the growth guide is preferably at least or up to 1,05x larger compared to the inner diameter of the filter unit or wherein the second diameter of the growth guide is preferably at least or up to 1,1x larger compared to the inner diameter of the filter unit or wherein the second diameter of the growth guide is preferably at least or up to 1,3x larger compared to the inner diameter of the filter unit or wherein the second diameter of the growth guide is preferably at least or up to 1,5x larger compared to the inner diameter of the filter unit.

Wherein the growth guide upper vertical end of the growth guide second section and the seed holder unit form a gas flow passage, wherein the smallest distance between the growth guide upper vertical end of the growth guide second section and the seed holder unit is smaller than 0,3x second diameter of the growth guide or smaller than 0,1x second diameter of the growth guide or smaller than 0,08x second diameter of the growth guide or smaller than 0,05x second diameter of the growth guide or smaller than 0,03x second diameter of the growth guide or smaller than 0,01x second diameter of the growth guide. The gap between the growth guide upper vertical end and the seed is preferably 1 mm, or 2 mm, or 3 mm, or 4 mm, or 5 mm.

The coating is according to a further preferred embodiment of the present invention preferably applied to the receiving space, in particular the surface of the receiving space inside the crucible volume and/or to the growth guide element respectively growth guide plate respectively gas distribution plate. The coating preferably comprises a material or a material combination that reduces permeability of Si vapor to 10⁻³ m²/s, or preferably 10⁻¹¹ m²/s, or more preferably 10⁻¹² m²/s, through the wall parts defining the receiving space and/or through the wall parts defining the growth guide element.

The coating preferably withstands temperatures above 2,000°C, in particular at least or up to 3,000°C or at least up to 3,000°C or up to 3,500°C or at least up to 3,500°C or up to 4,000°C or at least up to 4,000°C. This embodiment is beneficial since a modified receiving space and/or growth guide element has at least two layers of material, wherein one layer forms the structure of the receiving space and/or the growth guide element and wherein the other layer reduces or avoids permeability of Si vapor at the required operating temperatures of the crucible unit. The coating highly preferably comprises a material or multiple materials selected from a group of materials at least comprising carbon, in particular pyrocarbon and glassy carbon. Thus, the receiving space and/or the growth guide element is preferably coated with pyrocarbon and/or glassy carbon. The layer of pyrocarbon preferably has a thickness of more than or of up to 10µm, in particular of more than or of up to 20µm or of more than or of up to 50µm or of more than or of up to 100µm of more than or of up to 200µm of more than or of up to 500µm. The layer of glass carbon preferably has a thickness of more than or of up to 10µm, in particular of more than or of up to 20µm or of more than or of up to 50µm or of more than or of up to 100µm of more than or of up to 200µm of more than or of up to 500µm. The coating is generated according to a further preferred embodiment by chemical vapor deposition or wherein the coating is generated by painting, in particular of a precursor material, in particular phenol formaldehyde, and pyrolyzing after painting. This embodiment is beneficial since the coating can be generated in a reliable manner and this approach is more economical than making the housing entirely out of the covering material.

The heating unit comprises according to a further preferred embodiment of the present invention at least one heating element. The heating element is preferably arranged in vertical direction below the receiving space and/or below a bottom section of the crucible unit, wherein the bottom section of the crucible unit is surrounded by the receiving space. This embodiment is beneficial since the receiving space and/or the bottoms section surrounded by the receiving space can be heated by the heating element such that an axial thermal gradient can be formed. The heating element preferably at least partially and preferably to more than 50% or to more than 70% or up to 90% or completely underlaps the receiving space and/or the bottom section surrounded by the receiving space. This embodiment is beneficial since a homogeneous radial temperature distribution can be generated, in particular planes of homogeneous temperature can be generated in the radial direction with a temperature gradient going from hot to less hot in the upward axial direction.

The furnace apparatus comprises according to a further preferred embodiment of the present invention a gas flow unit. The gas flow unit preferably comprises a gas inlet for conducting gas into the crucible unit respectively into the crucible volume and a gas outlet for removing gas from the crucible unit respectively from the crucible volume. The gas inlet is preferably arranged closer to the bottom of the crucible unit compared to the gas outlet. Both the gas inlet and the gas outlet are preferably arranged inside the crucible volume. This embodiment is beneficial since the conditions inside the crucible volume and/or the vapor composition and/or fluid flow (direction and/or speed) inside the crucible can be affected respectively controlled.

The gas outlet comprises according to a further preferred embodiment of the present invention a gas conducting means, in particular a pipe. The gas outlet preferably comprises a sensor, in particular a temperature and/or pressure sensor, wherein the sensor is preferably arranged inside the conducting means, in particular a pipe, or as part of the conducting means, in particular a pipe, or attached to an outside wall of the conducting means, in particular a pipe. This embodiment is beneficial since the temperature conditions and/or pressure conditions can be monitored.

Additionally, or alternatively the gas inlet comprises according to a further preferred embodiment of the present invention a gas conducting means, in particular a pipe. The gas inlet preferably comprises a sensor, in particular a temperature and/or pressure sensor, wherein the sensor is preferably arranged inside the conducting means, in particular a pipe, or as part of the conducting means, in particular a pipe, or attached to an outside wall of the conducting means, in particular a pipe. This embodiment is beneficial since the temperature conditions and/or pressure conditions can be monitored.

The sensor in the gas inlet and/or gas outlet is according to a further preferred embodiment of the present invention a pyrometer. This embodiment is beneficial since the pyrometer is a remote-sensing device that can measure temperatures from a safe distance and the operating temperatures of the crucible unit are typically too high for measurement with a direct-sensing device such as a thermocouple.

The sensor in the gas inlet and/or gas outlet is according to a further preferred embodiment of the present invention in connection with a control unit respectively the control element. This embodiment is beneficial since the control unit respectively the control element receives sensor signals or sensor data. Thus, the control unit respectively the control element can output conditions inside the crucible unit, in particular in dependency of a time stamp, to an operator for supervising the production respectively growth process. Additionally, or alternatively the control unit respectively the control element can be equipped with control rules to control the furnace apparatus in dependency of the control rules, the time and/or the sensor output.

The receiving space is formed according to a further preferred embodiment of the present invention by one or at least one continuous trench or multiple recesses. The trench or the recesses preferably at least partially and preferably substantially or preferably completely surround a surface arranged or provided or materialized inside the crucible unit, in particular an inner surface of a wall and/or bottom section of the crucible unit, wherein the receiving space preferably has an annular shape. The heating element preferably underlaps at least 30% or at least 40% or at least 50% or at least 60% or at least 70% or at least 80% or at least 90% or at least 95% of a bottom surface of the receiving space and at least 20% or at least 30% or at least 40% or at least 50% or at least 60% or at least 70% or at least 80% or at least 90% or at least 95% of the surface which is at least partially surrounded by the receiving space. The surface which is at least partially surrounded by the receiving space preferably belongs to a solid wall respectively a crucible bottom wall respectively bottom section which extends at least a distance V1 in vertical direction wherein the receiving space extends a distance V2 in vertical direction between a receiving space bottom surface and a top of the lowest side wall member of the receiving space, wherein V2>V1 (this means: distance V2 is larger compared to distance V1), in particular V2>1,1xV1 or V2>1,2xV1 or V2>1,5xV1 or V2>2 xV1, or V2=V1 or V2<V1, in particular V2<1,1xV1 or V2<1,2xV1 or V2<1,5xV1 or V2<2 xV1.

Thus, the receiving space preferably surrounds a bottom section of the housing, in particular comprising the surface surrounded by the receiving space. The bottom section is preferably a solid material section. The crucible solid bottom section has preferably a height (in vertical direction) which is higher than 0,3 x the smallest distance between the receiving space and the central axis or which is higher than 0,5 x the smallest distance between the receiving space and the central axis or 0,7 x the smallest distance between the receiving space and the central axis or which is higher than 0,9 x the smallest distance between the receiving space and the central axis or 1,1 x the smallest distance between the receiving space and the central axis or which is higher than 1,5 x the smallest distance between the receiving space and the central axis.

The bottom section comprises according to a further preferred embodiment of the present invention an inner surface respectively the surface surrounded by the receiving space. The inner surface of the bottom section is arranged inside the crucible volume and preferably in parallel to the seed holder unit. The center of the inner surface and the center of the seed holder and/or the center of a seed wafer held by the seed holder unit are preferably arranged on the same vertical axis. The inner surface of the bottom section is preferably arranged in a predefined distance to the seed holder unit. The distance is higher preferably than 0,5x the smallest distance between the receiving space and the central axis or higher than 0,7x the smallest distance between the receiving space and the central axis or higher than 0,8x the smallest distance between the receiving space and the central axis or higher than 1x the smallest distance between the receiving space and the central axis or higher than 1,2x the smallest distance between the receiving space and the central axis or higher than 1,5x the smallest distance between the receiving space and the central axis or higher than 2x the smallest distance between the receiving space and the central axis or higher than 2,5x the smallest distance between the receiving space and the central axis. This embodiment is beneficial since the crucible volume has at least in sections and preferably mainly or completely an axisymmetric shape which supports homogeneous distribution of vaporized source material to the seed wafer or growing crystal.

The surface surrounded by the receiving space has according to a further preferred embodiment of the present invention at least a size of 0,5x the size of the top surface of the defined seed wafer or has at least a size of 0,8x the size of the top surface of the defined seed wafer or has at least a size of 0,9x the size of the top surface of the defined seed wafer or has at least a size of 1x the size of the top surface of the defined seed wafer or has at least a size of 1,1x the size of the top surface of the defined seed wafer. Additionally, or alternatively the center of the surface surrounded by the receiving space and the center of the top surface of the defined seed wafer are preferably arranged on the same vertical axis. Additionally, or alternatively the surface surrounded by the receiving space and the top surface of the defined seed wafer are preferably arranged in parallel to each other. This embodiment is beneficial since a distribution of heat via the surface surrounded by the receiving space can be carried out in a homogeneous manner.

In another preferred embodiment of the present invention, the defined distance between the receiving space and the center axis is zero and thus the source material fills the entire bottom of the crucible. A control unit respectively the control element is provided according to a further preferred embodiment of the present invention for controlling the pressure level inside the crucible unit and/or furnace and/or for controlling gas flow into the crucible unit and/or for controlling the heating unit. The heating unit is preferably controlled to establish an isotherm temperature profile parallel to the holder unit respectively orthogonal to the vertical direction respectively horizontal. This embodiment is beneficial since the control unit respectively the control element might use predefined rules and/or sensor data or sensor signals to monitor the growth process and to modify operation parameters of one or multiple of the before mentioned units to control crystal growth.

A filter unit is provided according to a further preferred embodiment of the present invention. The filter unit preferably surrounds the seed holder unit and/or wherein the filter unit is preferably at least partially arranged above the seed holder unit, in particular at least 60% (vol.) of the filter unit are arranged above the seed holder unit. The filter unit comprises a filter body, wherein the filter body comprises a filter input surface for inputting gas comprising Si vapor into the filter body and an output surface for outputting filtered gas, wherein the filter input surface is preferably arranged in vertical direction on a level below the level of the output surface. At least one or exactly one filter element is arranged between the filter input surface and the output surface. It is possible that the filter element forms the filter input surface and/or the output surface. The filter element preferably forms a trapping section for adsorbing and condensing Si vapor. This embodiment is beneficial since Si vapor can be captured inside the filter element and therefore reduces damage to furnace unit components that can caused by Si vapor. The trapping section preferably comprises at least or up to 50% (vol.) of the filter element volume or at least or up to 80% (vol.) of the filter element volume or at least or up to 90% (vol.) of the filter element volume. Thus, it is possible that 1%-50% (vol) or 10%-50% (vol.) or 1% -30% (vol.) of the filter element volume is a vapor section respectively a section in which the vaporized source material is present in a vapor configuration.

The filter element forms according to a further preferred embodiment of the present invention a gas flow path from the filter input surface to the output surface. The filter element preferably has a height S1 and the gas flow path through the filter element has a length S2, wherein S2 is at least 10 time longer compared to S1, in particular S2 is 100 times longer compared to S1 or S2 is 1,000 times longer compared to S1. This embodiment is beneficial since the filter element comprises sufficient internal surface area to adsorb and condense all Si vapor generated during one run respectively during growth of one crystal, in particular SiC crystal. Thus, the filter element preferably forms a porous high surface area for trapping Si sublimation vapor during PVT growth, in particular of SiC single crystals, in particular SiC of a second type compared to the SiC source material. The filter element preferably comprises a material having a surface are of at least 1 m²/g, or preferably of at least 10 m²/g, or highly preferably of at least 100 m²/g or most preferably of at least 1000 m²/g. The filter unit is according to a further preferred embodiment of the present invention arranged between a first part of the housing of the crucible unit and a second part of the housing of the crucible unit. At least 50% (vol.), in particular at least 80% (vol.) or 90% (vol.), of the first part of the housing of the crucible unit is arranged in vertical direction below the seed holder unit. A first crucible volume is present between the first part of the housing of the crucible unit and the seed holder, wherein the first crucible volume can be operated such that at least 80% or preferably 90% or more preferably 100% of the first crucible volume is above the condensation temperature T_{c} of silicon at the prevailing pressure. Additionally, up to 50% (vol.) or up to 20% (vol.) or up to 10% (vol.) of the first part of the housing of the crucible unit is arranged in vertical direction above the seed holder unit. Alternatively, at least 50% (vol.), in particular at least 80% (vol.) or 90% (vol.), of the second part of the housing of the crucible unit is arranged in vertical direction above the seed holder unit. A second crucible volume is preferably present between the second part of the housing of the crucible unit and the seed holder. At least 60%, or preferably 80%, or more preferably 90% of the filter element is below the condensation temperature T_{c}. This embodiment is beneficial since the source material is vapor respectively vaporized if at or above T_{c} and is condensate respectively condenses if at or below T_{c}. Thus, the fact that Si vapor condenses below a specific temperature can be used to trap condensed Si in the filter element. Therefore, the filter element is highly effective.

The filter unit is arranged according to a further preferred embodiment of the present invention between a first wall part of the first part of the housing and a further wall part of the second part of the housing. The filter body preferably forms a filter outer surface. The filter outer surface preferably connects the first wall part of the first part of the housing and the further wall part of the second part of the housing. The filter outer surface preferably forms a portion of the outer surface of crucible unit. This embodiment is beneficial since the filter unit can be arranged in such a manner that it increases the volume of the crucible unit without requiring one or multiple additional crucible housing components.

The filter outer surface comprises according to a further preferred embodiment of the present invention a filter outer surface covering element. The filter outer surface covering element is preferably a sealing element. The sealing element is preferably a coating. The coating is preferably generated at the filter surface or attached to the filter surface or forms the filter surface. The coating preferably comprises of a material or a material combination that reduces leakage from the crucible volume through the crucible housing to the furnace volume of sublimation vapors, in particular Si vapor, generated during one run, in particular by at least 50% (mass) or by at least 80% (mass) or by at least 90% (mass) or by more than 99% (mass) or by at least 99,9% (mass).

The coating preferably withstands temperatures above 2,000°C, in particular at least or up to 3,000°C or at least up to 3,000°C or up to 3,500°C or at least up to 3,500°C or up to 4,000°C or at least up to 4,000°C. The coating preferably comprises a material or multiple materials selected from a group of materials at least comprising carbon, in particular pyrocarbon and glassy carbon. This embodiment is beneficial since the filter unit can also form an outer barrier of the crucible unit. Thus, the filter unit preferably absorbs respectively captures Si and preferably also prevents Si vapor leakage. The ash content of the filter element is preferably below 5% (mass) or below 1% (mass). This means that the less than 5% or less than 1% of the mass of the filter element is ash.

The filter body forms according to a further preferred embodiment of the present invention a filter inner surface. The filter inner surface is preferably arranged in coaxial manner with respect to the filter outer surface. The filter body is preferably formed in a ring-shaped manner. The filter outer surface has preferably a cylindrical shape and/or the filter inner surface has preferably a cylindrical shape. The filter outer surface and/or the filter inner surface has the longest extension in vertical direction or in circumferential direction. This embodiment is beneficial since the filter unit can be positioned in a simple manner due to its shape. Additionally, or alternatively the filter inner surface surrounds a space above the seed holder unit. The space surrounded by the seed holder unit can act as cooling space for cooling the filter element and/or for cooling the seed holder unit. A cooling unit can be provided wherein the cooling unit preferably comprises at least one cooling pipe for guiding a cooling liquid. Said cooling pipe can be arranged to at least partially or at least mainly (more than 50% in circumferential direction) or completely surrounds the crucible unit. Additionally, or alternatively the cooling pipe can be arranged inside the crucible volume in particular in the space surrounded by the filter inner surface. However, it is also possible that the cooling pipe extends from the outside of the crucible unit through a wall of the crucible unit and/or a wall of the filter unit into the crucible volume, in particular into the space which is surrounded by the filter inner surface. It is additionally possible that the cooling pipe extends to the outside of the furnace. This embodiment is beneficial since the temperature inside the crucible unit can be controlled in an advantageous manner. Furthermore, it is possible to setup a temperature distribution profile inside the crucible volume having a much steeper gradient compared to a situation without a cooling unit.

The filter inner surface comprises according to a further preferred embodiment of the present invention a further filter inner surface covering element. The further filter inner surface covering element is preferably a sealing element. The sealing element is preferably a coating, wherein the coating is preferably generated at the filter surface or attached to the filter surface or forms the filter surface. The coating preferably comprises of a material or a material combination that reduces leakage from the crucible volume through the crucible housing to the furnace volume of sublimation vapors, in particular Si vapor, generated during one run, in particular by at least 50% (mass) or by at least 80% (mass) or by at least 90% (mass) or by more than 99% (mass) or by at least 99,9% (mass).

The coating preferably withstands temperatures above 2,000°C, in particular at least or up to 3,000°C or at least up to 3,000°C or up to 3,500°C or at least up to 3,500°C or up to 4,000°C or at least up to 4,000°C. The coating preferably comprises a material or multiple materials selected from a group of materials at least comprising carbon, in particular pyrocarbon and glassy carbon. This solution is beneficial since leakage of Si vapor into the space surrounded by the filter inner surface is prevented.

The filter element is preferably made of an active carbon block and/or one or multiple, in particular various, graphite foams including those made from carbonized bread and/or graphite rigid insulation and/or graphite flexible insulation.

The filter element comprises according to a further preferred embodiment of the present invention a filter element member. The filter element member preferably comprises filter particles and a binder. The filter particles preferably comprise carbon or consist of carbon. The binder preferably holds the filter particles in fixed relative positions to each other. The filter particles preferably withstand temperatures above 2,000°C, in particular at least or up to 3,000°C or at least up to 3,000°C or up to 3,500°C or at least up to 3,500°C or up to 4,000°C or at least up to 4,000°C. The binder preferably withstands temperatures above 1800°C, in particular above 2,000°C, in particular up to or above 2,000°C, in particular at least or up to 3,000°C or at least up to 3,000°C or up to 3,500°C or at least up to 3,500°C or up to 4,000°C or at least up to 4,000°C. This solution is beneficial since the solid filter element can maintain its structural integrity at the high operating temperatures of the crucible unit. The filter unit, in particular the filter element, is preferably a single use unit respectively element.

The binder comprises according to a further preferred embodiment of the present invention starch or wherein the binder consists of modified starch and/or glassy carbon precursors such as phenol formaldehyde and/or furfuryl alcohol and/or polymers thereof.

The furnace apparatus comprises according to a further preferred embodiment of the present invention a gas flow unit. The gas flow unit preferably comprises a gas inlet for conducting gas into the crucible unit and a gas outlet for removing gas from the crucible unit into the furnace or through the furnace to the outside of the furnace. The gas inlet is preferably arranged in gas flow direction before the filter unit, in particular before the filter input surface, in particular in gas flow direction before the receiving space, and wherein the gas outlet is arranged in gas flow direction after the filter unit. A filter-unit-gas-flow-path preferably extends from the filter input surface through the filter element to the filter output surface. Thus, a gas inlet is preferably arranged in a transformation zone within the crucible unit. The transformation zone preferably also comprises the seed holder unit and the receiving space. A source material can be transformed from a solid configuration into a vapor configuration and from the vapor configuration into a solid target body. The source material can be arranged inside the receiving space and wherein the solid target body can be held by the seed holder unit. The solid target body is a crystal, in particular a SiC crystal. Gas introduced via the gas inlet preferably mixes with the source material in the vapor configuration and/or during solidification. The gas outlet is preferably arranged in a trapping zone, wherein the trapping zone also comprises the output surface of the filter unit, wherein the gas composition in the trapping zone is preferably free of Si vapor respectively does not comprise Si vapor. The temperature in the trapping zone is preferably below the solidification temperature of gaseous Si respectively Si vapor. This embodiment is beneficial since the crystal growth process can be manipulated. It is e.g. possible to add one or multiple gases for doping the crystal. Additionally, or alternatively it is possible to modify, in particular to accelerate, the vapor transport from the receiving space to the seed wafer or crystal. Additionally, or alternatively the gas can be provided in a defined temperature or temperature range.

An inert gas, in particular argon, or a mixture of gases, in particular argon and nitrogen, can be introduced respectively is introduced via the gas inlet into the crucible unit, respectively into the crucible volume respectively into the transformation zone. The flowrate of the inert gas can be adjusted to optimize crystal growth parameters. The inert gas flow rate should be high enough to prevent any backward diffusion of sublimation species into the inlet tube and also to provide sufficient convective assistance to mass flux of sublimation species toward the crystal. However, the inert gas flow rate should not be so high as to cause entrainment of particulates which may incorporate into the crystal and cause defects, or be so high as to cause undesirable mass flux patterns that might for example cause plugging of the gap between the crystal and the growth guide. Suitable flowrates can be 100 cm³/min or 200 cm³/min, or 500 cm³/min or 1,000 cm³/min, or 2,000 cm³/min, or 5,000 cm³/min.

The size of the crucible housing can be configured respectively is modifiable according to a further preferred embodiment of the present invention. The crucible housing surrounds a first volume VI in a crystal growth configuration and the crucible housing surrounds a second volume VII in a coating regeneration configuration. The crystal growth configuration represents a configuration respectively a setting which is present during growth of a crystal respectively during solidification of vaporized source material at a seed wafer or at a growth front of a crystal growing at the seed wafer. The regeneration configuration represents a setting which is present in case no source material, seed holder, and seed wafer are provided and no crystal growth occurs. In the regeneration configuration the filter unit is preferably not part of the crucible unit and a lid which is arranged in the crystal growth configuration on top of the filter unit is preferably in contact with a side wall section of the crucible housing which is during the crystal growth configuration in contact with the lower end of the filter unit. Volume VI is preferably larger compared to volume VII, wherein volume VI is at least 10% or at least or up to 20% or at least or up to 30% or at least or up to 40% or at least or up to 50% or at least or up to 60% or at least or up to 70% or at least or up to 80% or at least or up to 100% or at least or up to 120% or at least or up to 150% or at least or up to 200% or at least or up to 250% larger than volume VII. This embodiment is beneficial since the crucible unit can be reconditioned after usage, in particular after one run or after several runs, in particular up to or at least three, up to or at least five or up to or at least ten runs. Thus, the overall service life of the crucible unit is very long. Thus, since also the heating unit can be used multiple times, a very cost-effective furnace apparatus is provided.

The housing preferably comprises in the crystal growth configuration at least one further wall member compared to the coating regeneration configuration. The further wall member is preferably a filter unit respectively the filter unit. The filter unit is removed in the coating regeneration configuration. A lower housing wall member of the housing, which is in the crystal growth configuration in contact with the filter unit and an upper housing wall member of the housing, which is in the crystal growth configuration in contact with the filter unit, are in contact with each other in the coating regeneration configuration. At least one gasket is preferably arranged between the lower housing wall member and the upper housing wall member in the coating regeneration configuration. In the crystal growth configuration at least one gasket is preferably arranged between the filter unit and the upper housing wall member and wherein at least one gasket is preferably arranged between the filter unit and the lower housing wall member. This embodiment is beneficial since leakage of gas respectively vapor is prevented in each configuration.

The crucible unit comprises according to a further preferred embodiment of the present invention in the coating regeneration configuration one or at least one receiving-space-gas-guiding-member. The receiving-space-gas-guiding-member extends into the receiving space to guide gas into the receiving space. This embodiment is beneficial since the gas which is introduced during the coating regeneration configuration more thoroughly contacts with the surface of the receiving space.

The gas inlet is according to a further preferred embodiment of the present invention arranged in a transformation zone within the crucible unit. The transformation zone preferably comprises the seed holder unit and/or the receiving space. This embodiment is beneficial since flow of vaporized source material and/or the composition of gas flowing upwards respectively from the receiving space to the seed wafer or growing crystal can be modified.

The receiving-space-gas-guiding-member preferably rests at least partially on the gas distribution member respectively wherein the gas distribution member preferably holds the receiving-space-gas-guiding-member, in particular by means of a form closure connection. This embodiment is beneficial since installation can be carried out in a fast and simple manner.

The receiving-space-gas-guiding-member preferably has an annular or circular shape. This embodiment is beneficial since the amount of vaporized source material better matches with the amount of vaporized material that solidifies at the seed wafer of crystal, compared to a different shape, like a rectangular receiving space shape. The receiving-space-gas-guiding-member preferably comprises carbon or consists of carbon and/or graphite.

The growth guide first section and the growth guide third section form according to a further preferred embodiment of the present invention, in particular on the underside, a growth guide fourth section and/or wherein the growth guide second section and the growth guide third section are arranged in an angle between 60° and 120°, in particular in an angle between 70° and 110°, in particular in an angle of 90°.

A grow-plate-gas-guide-member is preferably provided, for guiding gas to a surface on the upper side of the growth guide third section of the growth guide element. The grow-plate-gas-guide-member preferably has an annular or circular shape. The grow-plate-gas-guide-member is preferably arranged at the top respectively upper wall part of the housing. The grow-plate-gas-guide-member preferably comprises carbon or consists of carbon and/or graphite.

Thus, a method and reactor or furnace apparatus respectively apparatus for PVT growth of SiC single crystals preferably comprises of: Providing a furnace volume capable of housing a crucible unit, heaters, and insulation and/or providing a crucible unit with a lid inside the vacuum chamber and/or having a seed holder incorporated into or attached to the lid and/or having a SiC single crystal seed attached to the seed holder and/or having an axial heater positioned below the crucible unit such that radially flat temperature isotherms can be produced in the growing crystal and/or placing source material in the crucible unit such that there is no source material between the axial heat source and the seed and/or creating a vacuum in the crucible unit, heating and subliming the source material, and growing the crystal.

According to a further preferred embodiment of the present invention a gas-flow-path-boundary is formed or defined or provided or materialized between the crucible gas inlet tube and the crucible gas outlet tube for forming or defining or providing or materializing a gas flow path within the crucible housing.

According to a further preferred embodiment of the present invention the seed holder unit is arranged between the crucible gas inlet tube and the crucible gas outlet tube and forms a seed-holder-unit-gas-flow-path-boundary-section of the gas-flow-path boundary.

According to a further preferred embodiment of the present invention the receiving space is arranged or located between the crucible gas inlet tube and the seed holder unit for conducting gas flow around the receiving space and/or through the receiving space.

According to a further preferred embodiment of the present invention a source material holding plate respectively the gas distribution plate is provided (the terms "gas distribution plate" and "source material holding plate" can be preferably used synonymously), wherein the source material holding plate comprises an upper surface forming a bottom section of the receiving space and a lower surface forming a source-material-holding-plate-gas-flow-path-boundary-section.

According to a further preferred embodiment of the present invention the source-material-holding-plate comprises multiple through holes, wherein the multiple through holes extend from the upper surface of the source-material-holding-plate through a main body of the source-material-holding-plate to the lower surface of source-material-holding-plate.

According to a further preferred embodiment of the present invention at least the majority of the multiple through holes or each of the multiple through holes has a diameter of less than 12mm, in particular less than 10mm and preferably less than 6mm and highly preferably less than 2mm and most preferably of 1mm or less than 1mm. According to a further embodiment of the present invention the source-material-holding-plate preferably is a one-piece element or comprises multiple components, wherein said multiple components can be detachable coupled.

According to a further preferred embodiment of the present invention the number of through holes through the main body of the source-material-holding-plate, depends on the surface size of the upper surface of the source-material-holding-plate, wherein at least one though hole is provided per 10cm2 surface size of the upper surface.

According to a further preferred embodiment of the present invention the number of through holes per 10cm2 is higher in a radially outer section of the source-material-holding-plate compared to a radially inner section of the source-material-holding-plate, wherein the radially inner section extends up to 20% or 30% or 40% or 50% of the radial extension of the source-material-holding-plate, wherein the radially outer section of the source-material-holding-plate extends between the radially inner section and the radial end of the source-material-holding-plate.

According to a further preferred embodiment of the present invention the radially inner section of the source-material-holding-plate comprises no through holes.

According to a further preferred embodiment of the present invention the lower surface of the source-material-holding-plate forms together with a bottom wall section of the crucible housing a gas-guide-gap or gas-guide-channel for guiding gas from the crucible gas inlet tube to the receiving space or around the receiving space, in particular to the through holes of the source-material-holding-plate. The gas-guide-gap or gas-guide-channel preferably extends preferably mainly or completely in a horizontal plane.

According to a further preferred embodiment of the present invention the filter unit is arranged between the crucible gas outlet tube and the seed holder unit, wherein the filter unit forms a filter-unit- gas-flow-path-boundary-section for forming or defining or providing or materializing the filter gas flow path, wherein the filter gas flow path extends between a filter input surface and a filter output surface. The filter input surface, in particular a center of the filter input surface, is preferably arranged closer to the seed holder unit compared to the filter output surface, in particular a center of the filter output surface. Additionally, or alternatively the filter output surface, in particular a center of the filter output surface, is arranged closer to the crucible gas outlet tube compared to the filter input surface, in particular a center of the filter input surface.

According to a further preferred embodiment of the present invention the growth guide forms a growth-guide-gas-path-section-boundary for guiding gas flow into the direction of the seed holder unit. The growth guide and the seed holder unit form a gas-flow passage, wherein gas flow velocity through the gas flow passage is preferably set-up between 1cm/s and 10cm/s and highly preferably between 2cm/s and 6cm/s and most preferably between 2,5cm/s and 5,5cm/s or 2,5cm/s and 4,5cm/s or 3cm/s and 5,5cm/s or 3,5cm/s and 4cm/s. The seed holder unit and the growth guide preferably are arranged in a distance to each other to form the gas flow passage. The distance between the seed holder unit and the growth guide is preferably more than 0,1% of the diameter of the seed holder unit and highly preferably more than or up to 2 % of the diameter of the seed holder unit and most preferably between 0,1% and 20%, in particular between 1% and 10% or between 1% and 5%, of the diameter of the seed holder unit. The distance between the seed holder unit and the growth guide is preferably less than 20cm or less than 15cm or highly preferably less than 10cm and most preferably in a range between 0,5cm and 10cm.

According to a further preferred embodiment of the present invention gas flow through the furnace unit preferably takes the following route: Provided through the crucible gas inlet tube and introduced into the crucible housing via the crucible gas inlet tube then guided through the gas flow gap then guided through the source material plate holes the guided between and around the particles of the source material then guided from the source material to the seed wafer or crystal growth face as the case may be, then guided across the seed wafer or crystal growth face as the case may be, then guided toward the gap between the seed holder and the growth guide then through the gap between the seed holder and the growth guide, then guided towards the filter unit, then through the filter unit, then across the bottom surface of the filter lid to the crucible vacuum outlet tube, then through the crucible vacuum outlet tube, then out of the crucible housing through the crucible vacuum outlet.

According to a preferred embodiment of the present invention the filter unit comprises one filter element, wherein the filter element or filter unit preferably has a ring-shaped form. The ring-shaped form preferably has an outer surface and an inner surface, wherein the inner surface preferably forms a through hole. The inner surface and the outer surface can be of the same type, in particular circular, or of different type, in particular circular and rectangular or of different (preferably cross-sectional) shapes, wherein the inner surface and or the outer surface can be different in dependency of the height of the filter unit. E.g. the outer form can have a cylindrical shape and the inner form can have a shape differing from the cylindrical shape. Furthermore, the diameter of the inner and/or outer surface can be different at different heights of the filter unit.

The filter body forms according to a further preferred embodiment of the present invention one receiving slot for receiving one filter element or multiple receiving slots for receiving multiple filter elements. The one filter element is preferably a disposable filter element or the multiple filter elements are preferably disposable filter elements. The filter body is preferably reusable. Disposable preferably describes that the filter element is replaced after a defined number of runs, in particular after one, two or three or up to five or up to ten runs. Reusable preferably describes that the filter body is used for more runs compared to a filter element. The filter body is preferably made of carbon, in particular graphite, or consists of graphite.

A blind-hole-center-axis or a through-hole-center-axis is preferably arranged in parallel or coaxial to a seed-holder-unit-center-axis. A blind-hole-center-axis or a through-hole-center-axis is preferably arranged in a distance of less than 50% of the diameter or average diameter or largest diameter of the seed holder unit to the seed-holder-unit-center-axis and preferably in a distance of less than 30% of the diameter of the seed holder unit to the seed-holder-unit-center-axis and highly preferably in a distance of less than 15% of the diameter or average diameter or largest diameter of the seed holder unit to the seed-holder-unit-center-axis and most preferably in a distance of less than 5% of the diameter of the seed holder unit to the seed-holder-unit-center-axis.

The blind hole or through hole preferably has a diameter or average diameter or largest diameter of more than 20% of the diameter or average diameter or largest diameter of the seed holder unit and preferably of more than 50% of the diameter of the seed holder unit and highly preferably of more than 80% of the diameter of the seed holder unit and most preferably of up to, exactly or more than 100% of the diameter of the seed holder unit.

The diameter or average diameter or largest diameter of the outer surface of the filter unit is preferably more than 110% of the diameter or average diameter or largest diameter of the seed holder unit or highly preferably more or up to 125% of the diameter or average diameter or largest diameter of the seed holder unit or most preferably more or up to 150% of the diameter or average diameter or largest diameter of the seed holder unit.

The blind hole of the filter unit preferably extends from the side of the filter input surface into the direction of the filter output surface more or up to 10% of the distance or average distance between the input surface of the filter unit and the output surface of the filter unit or preferably more or up to 20% of the distance or average distance between the input surface of the filter unit and the output surface of the filter unit or highly preferably more or up to 50% of the distance or average distance between the input surface of the filter unit and the output surface of the filter unit or most preferably more or up to 70% of the distance or average distance between the input surface of the filter unit and the output surface of the filter unit.

The blind hole of the filter unit preferably extends from the side of the filter input surface into the direction of the filter output surface preferably between 5% and 10% of the distance or average distance between the input surface of the filter unit and the output surface of the filter unit or preferably between 5% and 30% of the distance or average distance between the input surface of the filter unit and the output surface of the filter unit or highly preferably between 10% and 90% of the distance or average distance between the input surface of the filter unit and the output surface of the filter unit or most preferably between 15% and 95% of the distance or average distance between the input surface of the filter unit and the output surface of the filter unit.

According to a further preferred embodiment of the present invention the heat dissipating means is a filter through hole, a blind hole or a filter-cooling-unit.

Thus, the filter unit preferably comprises a filter-cooling-unit for cooling a filter-unit-input-surface-section of the filter unit input surface.

The filter-cooling-unit preferably comprises a filter-cooling-unit-gas-inlet and a filter-cooling-unit-gas-outlet and a filter-unit-cooling-gas-guide for guiding gas introduced via the filter-cooling-unit-gas-inlet along and/or through the filter unit, in particular the filter body and/or filter element/s, to remove thermal energy from at least the filter-unit-input-surface-section. The filter-unit-input-surface-section preferably at least partially overlaps in axial direction of the seed holder unit the backside of the seed holder. The filter-unit-input-surface-section preferably overlaps, in particular in vertical direction, at least 30% of the backside surface of the seed holder unit and highly preferably at least 70% of the backside surface of the seed holder unit and most preferably between 75% and 100% or at least or up to 100% of the backside surface of the seed holder unit.

The filter-cooling-unit-gas-inlet is preferably coupled via a first-cooling-gas-pipe with a cooling-gas-source and the filter-cooling-unit-gas-outlet is preferably coupled via a second-cooling-gas-pipe with a cooling-gas-receiving-space, in particular the cooling-gas-source, for feeding back the heated cooling gas. The first-cooling-gas-pipe and the second-cooling-gas-pipe preferably extend through the crucible lid to the furnace and highly preferably though a furnace wall to the outside of the furnace apparatus.

According to a further preferred embodiment of the present invention the filter unit is arranged insider a crucible housing, in particular entirely surrounded by crucible walls, wherein the filter body forms a filter outer surface and preferably a filter inner surface, wherein the filter inner surface preferably forms a filter blind hole or a filter through hole.

According to a further preferred embodiment of the present invention a pressure unit for setting up a crucible volume pressure inside the crucible volume provided, wherein the pressure unit is configured to cause crucible volume pressure below 66661,2 Pa or in a range between 2666,45 Pa and 39996,7 Pa. This embodiment is beneficial since due to the pressure above 2666,45 Pa a dense gas flow is generated that causes an improved mass flux from the source material to the seed wafer. The pressure unit is preferably configured to a establish a furnace volume pressure inside the furnace volume but outside the crucible housing, wherein the pressure unit is configured to set up the furnace volume pressure higher compared to the crucible volume pressure, in particular more than 20 Pa or preferably more than 133,322 Pa or highly preferably more than 666,612 Pa higher compared to the crucible volume pressure.

According to a highly preferred embodiment of the present invention a pressure unit for setting up a crucible volume pressure inside the crucible volume is provided. The pressure unit is preferably configured to cause a crucible volume pressure (P1) above 2666,45 Pa and preferably above 5000Pa or in a range between 2666,45 Pa and 50000,00 Pa, in particularly during a production run. The pressure above 2666,45 Pa and preferably above 5000Pa or in a range between 2666,45 Pa and 50000,00 Pa, is highly preferably generated via the crucible gas inlet tube and/or via the crucible gas outlet tube, in particular by means of a carrier gas supply into the crucible volume, in particular by means of a gas pump, and/or a gas removal from the crucible volume, in particular by means of a vacuum gas pump. The pressure unit is preferably also configured to cause furnace volume pressure (P2) identical or higher compared to crucible volume pressure, in particular of more than 20 Pa or preferably of more than 133,322 Pa or highly preferably of more than 666,612 Pa higher compared to the crucible volume pressure.

The above-mentioned object is also solved by a method according to claim 19. Said method is preferably a method for producing SiC material. Said method preferably comprises at least the steps: Providing at least one furnace apparatus according to any of the mentioned claims or any of the herein described furnace apparatuses, arranging source material in a receiving space within the crucible housing, heating the source material; adjusting the position of the seed holder unit during operation of the furnace apparatus for positioning a growth face of the growing SiC crystal within a defined growth zone.

Boule respectively the SiC crystal grown, in particular during one run on a seed wafer preferably has a length of more than 10cm and preferably more than 20cm and wherein a surrounding surface between a plane top surface and a growth face / end face has a defined diameter along at least 50% and preferably at least 75% of the length of the boule, wherein the diameter is smaller than 1,1 x diameter and preferably smaller than 1,05 x diameter of the top surface.

The mentioned furnace apparatus can be a modification of a furnace apparatus according to PCT/EP2021/082331. The subject-matter of PCT/EP2021/082331 is entirely incorporated into the present subject-matter by reference.

Further benefits, goals and features of the present invention will be described by the following specification of the attached figures, in which components of the invention are exemplarily illustrated. Components of the devices and methods according to the inventions, which match at least essentially with respect to their function, can be marked with the same reference sign, wherein such components do not have to be marked or described in all figures.

For a more complete understanding of the present invention and advantages thereof, reference is now made to the following description taken in conjunction with the accompanying drawings. The invention is explained in more detail below using an exemplary embodiment which is specified in the schematic figures of the drawings, in which:

### Brief Description of the Drawings:

- Fig. 1: shows a schematic illustration of a first example of a furnace apparatus, wherein the furnace apparatus comprises a position adjustment unit for adjustment of the position of the seed holder unit during operation of the furnace apparatus;
- Fig. 2: shows a further schematic illustration of the furnace apparatus shown in fig. 1, wherein the position adjustment unit has moved the seed holder unit to a second position to keep the growth face of the crystal in a defined position range,
- Fig. 3: shows a further schematic illustration of the furnace apparatus shown in fig. 2, wherein the position adjustment unit has moved the seed holder unit to a third position to keep the growth face of the crystal in a defined position range,
- Fig. 4: shows a second example of a furnace apparatus, wherein the furnace apparatus comprises another position adjustment unit for adjustment of the position of the seed holder unit during operation of the furnace apparatus;
- Fig. 5: shows a third example of a furnace apparatus, wherein the furnace apparatus comprises another position adjustment unit for adjustment of the position of the seed holder unit during operation of the furnace apparatus; and

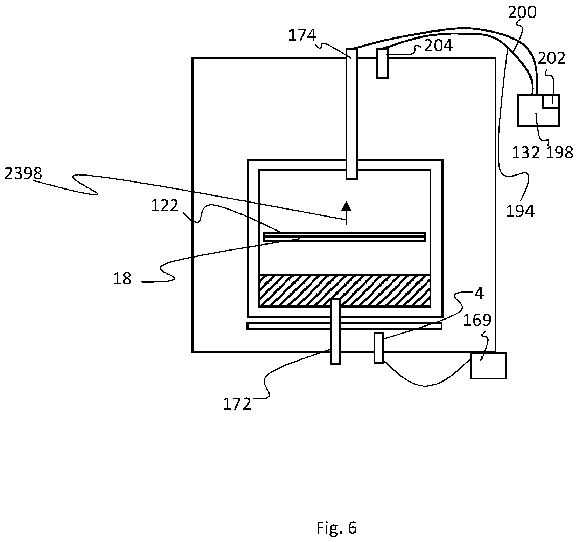

- Fig. 6: shows a further schematic illustration of a furnace apparatus according to the present invention, wherein the furnace apparatus comprises a position adjustment unit for adjustment of the position of the seed holder unit during operation of the furnace apparatus.

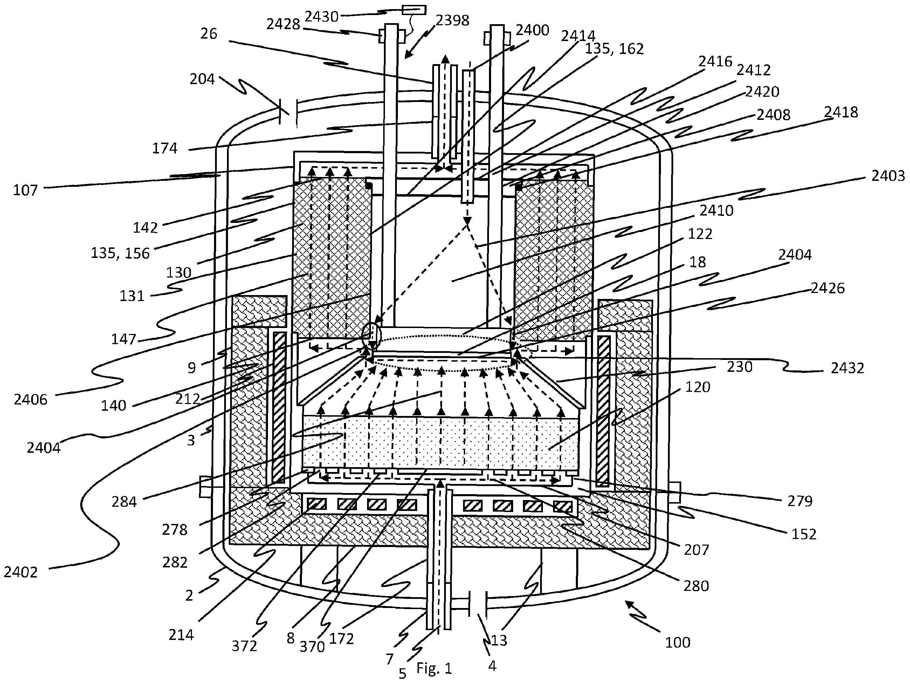

Fig. 1 shows an example of a PVT reactor 100 used according to the present invention. the furnace apparatus 100 preferably comprises a crucible gas flow unit 170. The crucible gas flow unit 170 preferably comprises a crucible gas inlet tube 172 for conducting gas into the crucible volume 116, wherein the crucible gas inlet tube 172 is highly preferably arranged in vertical direction below the receiving space 118. The receiving space 118 is preferably located between the crucible gas inlet tube 172 and the seed holder unit 122 for conducting gas flow around the receiving space 118 and/or through the receiving space 118.

A source-material-holding-plate 278 can be provided, wherein the source-material-holding-plate 278 comprises an upper surface 370 preferably forming a bottom section of the receiving space 118 and a lower surface 372 preferably forming a source-material-holding-plate-gas-flow-path-boundary-section. The source-material-holding-plate 278 preferably comprises multiple through holes 282, in particular more than 10 or preferably more than 50 or highly preferably up to 100 or most preferably up to or more than 1000, wherein the multiple through holes 282 extend from the upper surface 370 of the source-material-holding-plate 278 through a main body of the source-material-holding-plate 278 to the lower surface 372 of source-material-holding-plate 278. At least the majority of the multiple through holes 282 has a diameter of less than 12mm, in particular less than 10mm and preferably less than 6mm and highly preferably less than 2mm and most preferably of 1mm or less than 1mm. The number of through holes 282 through the main body of the source-material-holding-plate 278, preferably depends on the surface size of the upper surface 370 of the source-material-holding-plate 278, wherein at least one though hole 282 is provided per 10cm² surface size of the upper surface 370. The number of through holes 282 per 10cm² is preferably higher in a radially outer section of the source-material-holding-plate 278 compared to a radially inner section of the source-material-holding-plate, wherein the radially inner section extends up to 20% or 30% or 40% or 50% of the radial extension of the source-material-holding-plate 278, wherein the radially outer section of the source-material-holding-plate 278 extends between the radially inner section and the radial end of the source-material-holding-plate 278. The lower surface 372 of the source-material-holding-plate 278 preferably forms together with a bottom wall section 207 of the crucible housing 110 a gas-guide-gap 280 or gas-guide-channel for guiding gas from the crucible gas inlet tube 172 to the receiving space 118 or around the receiving space 118, in particular to the through holes 282 of the source-material-holding-plate 278. Additionally, or alternatively a pressure unit 132 for setting up a crucible volume pressure P1 inside the crucible volume 116 is provided, wherein the pressure unit 132 is configured to cause crucible volume pressure P1 above 2666,45 Pa and preferably above 5000Pa or in a range between 2666,45 Pa and 50000,00 Pa. A crucible gas outlet tube 174 for removing gas from the crucible volume 116 is preferably provided, wherein the crucible gas inlet tube 172 is arranged in gas flow direction preferably before a filter unit 130 and wherein the crucible gas outlet tube 174 is arranged in gas flow preferably direction after a filter unit 130. The filter unit 130 can be arranged inside the crucible volume 116 between the crucible gas inlet tube 172 and the crucible gas outlet tube 174 for capturing at least Si₂C sublimation vapor, SiC₂ sublimation vapor and Si sublimation vapor. The filter unit 130 preferably forms a filter-unit-gas-flow-path 147 from the filter input surface 140 to the filter output surface 142, wherein the filter gas flow path is part of the gas flow path between the crucible gas inlet tube 172 and the crucible gas outlet tube 174, wherein the filter unit 130 preferably has a height S1 and wherein the filter-unit-gas-flow-path 147 through the filter unit 130 preferably has a length S2, wherein S2 is at least 2 times, in particular 10 times, longer compared to S1. The filter unit 130 forms preferably a filter outer surface 156, wherein the filter outer surface 156 comprises a filter outer surface covering element, wherein the filter outer surface covering element is a sealing element, wherein the sealing element is preferably a filter coating 135, wherein the filter coating 135 is generated at the filter outer surface 156 or attached to the filter outer surface 156 or forms the filter outer surface 156. The filter coating 135 of the filter outer surface 156 is preferably formed by a layer of pyrocarbon which has a thickness of more than 10µm, in particular of more than or of up to 20µm or of more than or of up to 50µm or of more than or of up to 100µm of more than or of up to 200µm of more than or of up to 500µm, and/or wherein the filter coating 135 of the filter outer surface 156 is formed by a layer of glassy carbon which has a thickness of more than 10µm, in particular of more than or of up to 20µm or of more than or of up to 50µm or of more than or of up to 100µm of more than or of up to 200µm of more than or of up to 500µm.

Reference number 2398 refers to a position adjustment unit for repositioning the position of a growth face of the growing SiC crystal 17 and/or for repositioning the seed holder unit 122.

The position adjustment unit 2398 comprises at least one repositioning element 2412. The repositioning element 2412 is preferably a rod-like element or a piston-like element, wherein the repositioning element 2412 is preferably releasably or none-releasably coupled with the seed holder unit 122. Thus, a position of the repositioning element 2412 preferably defines the position of the seed holder unit 122. It is possible that one or multiple repositioning elements 2412 are provided. The repositioning element 2412 is preferably made of graphite. The repositioning element 2412 is preferably directly or indirectly coupled with an actuator unit 2428, wherein the actuator unit 2428 is preferably a motor, in particular an electric motor. The actuator unit 2428 is preferably operated by a control device 2430, wherein the control device preferably comprises a CPU and/or GPU and/or FPGA. The control device 2430 preferably controls the position of the seed holder unit 122 in dependency of time and/or sensor data, in particular data representing the weight and/or size and/or mass and/or length of the crystal 17. Reference number 2432 preferably indicates a growth zone, wherein the growth zone 2432 preferably extends between a first growth zone boundary and a second growth zone boundary, wherein the first growth zone boundary and the second growth zone boundary are in the length direction of the crystal spaced apart from each other in a distance of less than 50cm and preferably in a distance of less than 20cm and particular preferably in a distance of less than 10cm and highly preferably in a distance of less than 5cm and most preferably in a distance of less than 1cm.

The furnace apparatus 100 preferably comprises a further gas inlet 2400. The further gas inlet 2400 is preferably arranged on a first side 2409 of the seed holder unit 122 and the crucible gas inlet 172 is preferably arranged on a second side 2411 of the seed holder unit 122. The gas feed via the further gas inlet 2400 preferably follows a defined gas-flow-path 2403. A part 2404 of the gas-flow-path 2403 goes through a modulation section 2402 for increasing the velocity of said gas. Due to the increased velocity the growing crystal becomes modulated, thus the crystal 17 growth in such a manner that the surface 2434 between the growth face 2426 and the surface which is coupled to the seed holder unit 122 growth parallel to the length direction L of the crystal 17 respectively in an angle of less than 20° and preferably less than 10° and highly preferably less than 5° and most preferably less than 2° to the length direction of the crystal 17. The modulation section 2402 is preferably formed on one side by the seed holder unit 122 and/or the crystal 17 and on the other side by a crucible housing element, in particular wall segment, and/or a surface 2406 of the filter unit 130.

Reference number 2410 indicates a gas insertion space into which gas can be inserter via the further gas inlet 2400 and which is preferably fluidly connected with the modulation section 2402. The gas insertion space 2410 is preferably limited on one side by a further-gas-sealing-unit 2408. The further-gas-sealing-unit 2408 has a first side surface 2414 and a second side surface 2416, wherein the first side surface 2414 limits the gas insertion space 2410 and wherein the second side surface 2416 limits a section of the gas flow path between the outlet 142 of the filter unit 130 and the crucible gas outlet 174. Sealed openings 2420 respectively through-holes through the further-gas-sealing-unit 2408 are preferably provided to allow movement of the repositioning element 2412.

Therefore, the present invention refers to a furnace apparatus 100, in particular a furnace apparatus 100 for growing crystals, in particular for growing SiC crystals 17. Said furnace apparatus 100 preferably comprises a furnace unit 102, wherein the furnace unit 102 comprises a furnace housing 108 with an outer surface 242 and an inner surface 240, at least one crucible unit 106, wherein the crucible unit 106 is arranged inside the furnace housing 108, wherein the crucible unit 106 comprises a crucible housing 110, wherein the crucible housing 110 has an outer surface 112 and an inner surface 114, wherein the inner surface 114 at least partially defines a crucible volume 116, wherein a receiving space 118 for receiving a source material 120 is arranged or formed inside the crucible volume 116, wherein a seed holder unit 122 for holding a defined seed wafer 18 is arranged inside the crucible volume 116, wherein the furnace housing inner wall 240 and the crucible housing outer wall 112 define a furnace volume 104, at least one heating unit 124 for heating the source material 120, wherein the receiving space 118 for receiving the source material 120 is at least in parts arranged below the seed holder unit 122. The furnace apparatus 100 preferably also comprises a position adjustment unit 2398 for adjustment of the position of the seed holder unit 122 during operation of the furnace apparatus 100 is provided, wherein the position adjustment unit 2398 is configured to increase the distance between the seed holder unit 122 and the receiving space 118 by moving the seed holder unit 112 away from the receiving space 118.

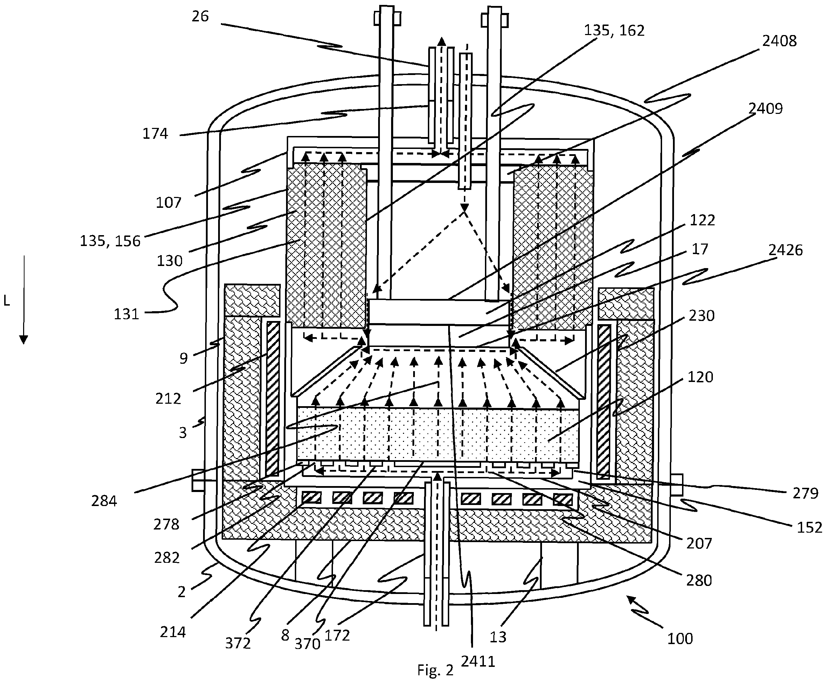

Fig. 2 shows a second state during one run. It shows that the growth face 2424 is arranged within the growth zone 2432 and the seed holder unit 122 is moved away from the source material receiving space.

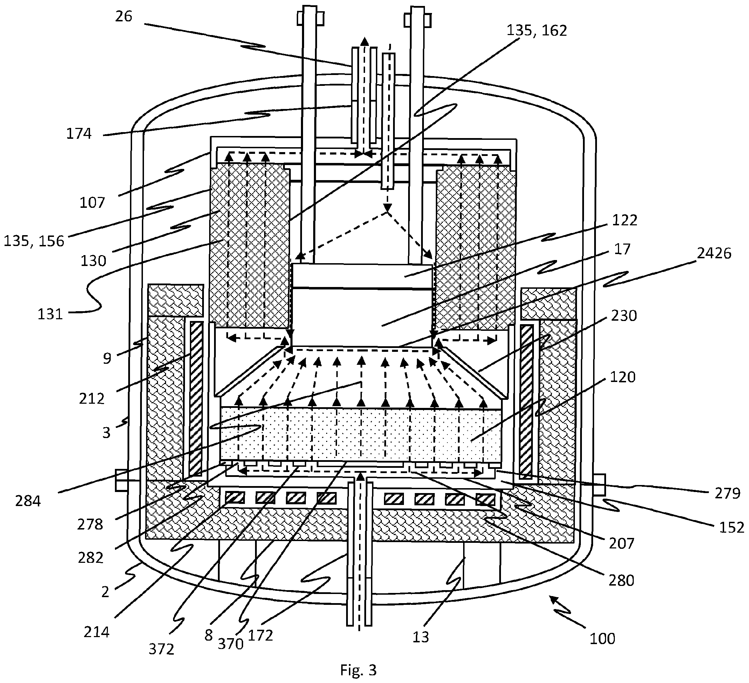

Fig. 3 shows a third state during said run, wherein fig. 3 shows that the growth face 2424 is arranged within the growth zone 2432 and the seed holder unit 122 is moved even more away from the source material receiving space.

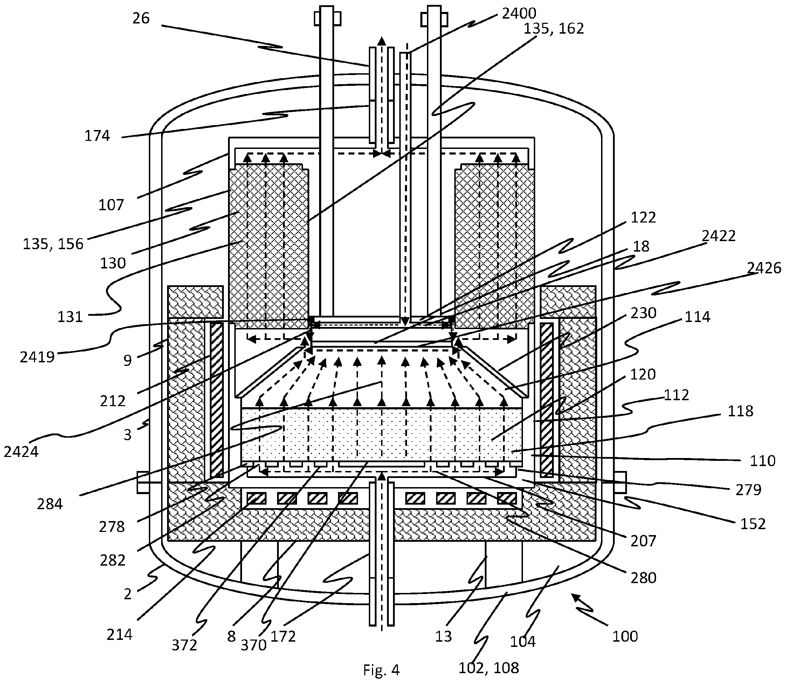

Fig. 4 shows a further schematic example of a furnace apparatus 100 according to the present invention. According to this embodiment the further gas inlet 2400 is coupled with the seed holder unit 122 for guiding gas through the further gas inlet 2400 into hollow sections 2422 of the seed holder unit 122. The seed holder unit 122 can be equipped with gaskets 2419 for sealing the first side 2409 from the second side 2411. In that case the further-gas-sealing-unit 2408 is not necessary. However, instead of gasket /s 2419 the further-gas-sealing-unit 2408 can be provided. The hollow sections 2422 are preferably configured to feed the gas to a surface 2424 between the first side 2409 of the seed holder unit 122 and the second side 2411 of the seed holder unit 122.

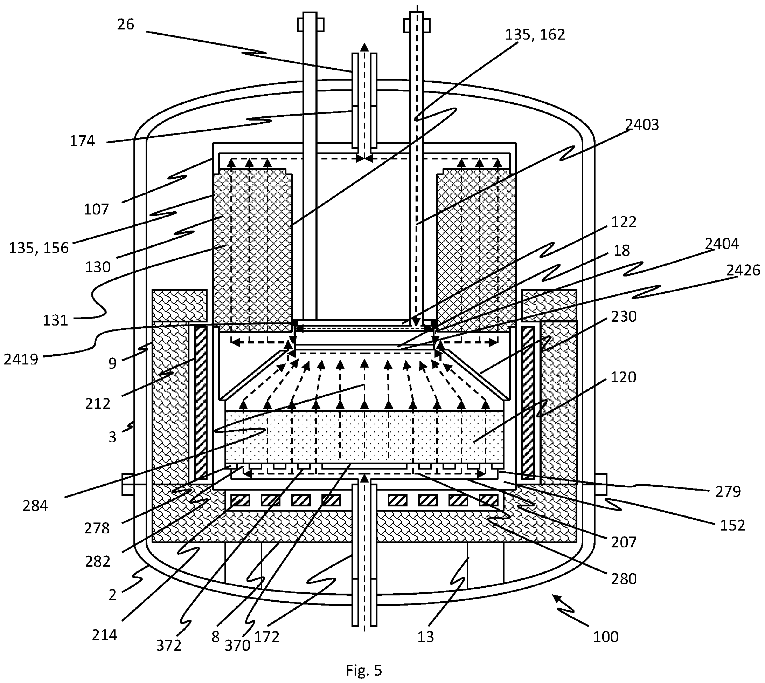

Fig. 5 schematically shows a further example of the furnace apparatus 100 according to the present invention. It shows that alternatively the filter unit 130 can be avoided. Furthermore, the repositioning element/s (not shown) do not have to be rod-like elements but can be arranged in the side walls of the crucible housing.

### List of reference numbers

| | | | |
|---|---|---|---|
| 2 | Furnace housing (lower part) | 7 | Crucible gas inlet connection piece |
| 3 | Furnace housing (upper part) | 8 | Bottom insulation |
| 4 | Furnace gas inlet (optional) | 9 | Side insulation |
| 5 | Crucible gas inlet | 13 | Crucible leg |
| 17 | Crystal | 174 | Crucible vacuum outlet tube |
| 18 | Seed wafer | 198 | Feed gas mixture |
| 26 | Crucible vacuum outlet | 202 | vacuum control element |
| 100 | Furnace respectively furnace apparatus respectively PVT reactor | 278 | source-material-holding-plate |
| | | 280 | gas-guide-gap |
| 102 | furnace unit | 282 | through holes |
| 104 | Furnace volume | 296 | Vent gas |
| 107 | Crucible lid respectively filter cover | 370 | upper surface of source-material- |
| 108 | furnace housing | | holding-plate |
| 110 | crucible housing | 372 | lower surface of source-material- |
| 112 | outer surface | | holding-plate |
| 116 | crucible volume | 2398 | position adjustment unit |
| 118 | receiving space | 2400 | further gas inlet |
| 120 | PVT source material | 2402 | modulation section |
| 122 | Seed holder | 2403 | gas flow path |
| 123 | transport path of seed holder during run | 2404 | part of the gas flow path |
| | | 2406 | surface of the filter unit |
| 130 | Filter | 2408 | further-gas-sealing-unit |
| 132 | pressure unit | 2409 | first side of seed holder unit |
| 135 | filter coating | 2410 | gas insertion space |
| 140 | filter input surface | 2411 | second side of seed holder unit |
| 142 | filter output surface | 2412 | repositioning element |
| 147 | filter-unit-gas-flow-path | 2414 | first side surface |
| 152 | Crucible base | 2416 | second side surface |
| 156 | filter outer surface | 2418 | gasket |
| 170 | crucible gas flow unit | 2419 | gasket |
| 172 | Crucible gas inlet tube | 2420 | sealed opening |
| 2422 | hollow section | 2428 | actuator |
| 2424 | surface between first and second side of the seed holder unit | 2430 | control device |
| | | 2432 | growth zone |
| 2426 | growth face | 2434 | crystal side surface |

## Claims

1. Furnace apparatus (100), in particular a furnace apparatus (100) for growing crystals, in particular for growing SiC crystals (17),
comprising
a furnace unit (102),
wherein the furnace unit (102) comprises a furnace housing (108) with an outer surface (242) and an inner surface (240),
at least one crucible unit (106),
wherein the crucible unit (106) is arranged inside the furnace housing (108),
wherein the crucible unit (106) comprises a crucible housing (110),
wherein the crucible housing (110) has an outer surface (112) and an inner surface (114), wherein the inner surface (114) at least partially defines a crucible volume (116),
wherein a receiving space (118) for receiving a source material (120) is arranged or formed inside the crucible volume (116),
wherein a seed holder unit (122) for holding a defined seed wafer (18) is arranged inside the crucible volume (116),
wherein the furnace housing inner wall (240) and the crucible housing outer wall (112) define a furnace volume (104),
at least one heating unit (124) for heating the source material (120),
wherein the receiving space (118) for receiving the source material (120) is at least in parts arranged below the seed holder unit (122),
**characterized in that**
a position adjustment unit (2398) for adjustment of the position of the seed holder unit (122) during operation of the furnace apparatus (100) is provided,
wherein the position adjustment unit (2398) is configured to increase the distance between the seed holder unit (122) and the receiving space (118) by moving the seed holder unit (112) away from the receiving space (118).

2. Furnace according to claim 1,
**characterized in that**
the furnace apparatus (100) comprises a crucible gas flow unit (170), wherein the crucible gas flow unit (170) comprises a crucible gas inlet (172) for conducting gas into the crucible volume (116) and a crucible gas outlet (174) for removing gas from the crucible volume (116), wherein a gas flow path is defined between the crucible gas inlet (172) and the crucible gas outlet (174),
wherein a further gas inlet (2400) is provided for conducting gas into the crucible volume (116), wherein at least one modulating section (2402) for modulating a part (2404) of a gas flow path (2403) of gas insertable via the further gas inlet (2400) is formed for modulating growth of the SiC crystal.

3. Furnace according to claim 2,
**characterized in that**
the modulating section (2402) of the gas flow path (2403) defines a high velocity passage for increasing the gas flow velocity, wherein the modulating section (2402) is formed on one side at least partially by the seed holder unit (122) and/or the seed wafer (18) and/or the growing crystal (17).

4. Furnace according to claim 3,
**characterized in that**
the modulating section (2402) is formed on another side by a surface of a filter unit (130) and/or a wall member of the crucible unit (106).

5. Furnace according to claims 2 to 4,
**characterized in that**
the further gas inlet (2400) is arranged on a first side (2409) of the seed holder unit (122) and the crucible gas inlet (172) is arranged on a second side (2411) of the seed holder unit (122).

6. Furnace according to claims 2 to 5,
**characterized in that**
a further-gas-sealing-unit (2408) is provided for blocking a direct gas path from the further gas inlet (2400) to the crucible gas outlet (174).

7. Furnace apparatus according to claim 6,
**characterized in that**
the filter unit (130) is arranged inside the crucible volume (116) between the crucible gas inlet tube (172) and the crucible gas outlet tube (174) for capturing at least Si₂C sublimation vapor, SiC₂ sublimation vapor and Si sublimation vapor, wherein the gas path from the further gas inlet (2400) extends through the filter unit (2400) to the crucible gas outlet (174)

8. Furnace according to claim 7,
**characterized in that**
the further-gas-sealing-unit (2408) comprises a first side surface (2414) and a second side surface (2416), wherein the first side surface (2414) and the first side (2409) of the seed holder (122) define a gas insertion space (2410) for inserting gas via the further gas inlet (2400).

9. Furnace according to claim 8,
**characterized in that**
the position adjustment unit (2398) is configured to move the seed holder unit (122) in a defined direction for reducing the size of the space between the first side surface (2412) and the first side (2409) of the seed holder (122).

10. Furnace according to claim 9,
**characterized in that**
the position adjustment unit (2398) comprises at least one repositioning element (2412), wherein the repositioning element (2412) is attached to the seed holder unit (122) or attachable to the seed holder unit (122) and wherein the repositioning element (2412) extend through a sealed opening (2420) of the further-gas-sealing-unit (2408), and
the further-gas-sealing-unit (2408) is coupled, in particular via one or multiple gaskets (2418), to the filter unit (130).

11. Furnace according to claims 2 to 5,
**characterized in that**
the position adjustment unit (2398) comprises at least one repositioning element (2412), wherein the repositioning element (2412) is attached to the seed holder unit (122) or attachable to the seed holder unit (122).

12. Furnace according to claim 11,
**characterized in that**
the repositioning element (2412) is a tube, wherein the tube forms the further gas inlet (2400) and wherein the seed holder unit (122) comprises at least one hollow section (2422) or multiple hollow sections (2422), wherein the tube and the hollow section (2422) or hollow sections (2422) are connected to guide gas through the tube and the hollow section (2422) or hollow sections (2422) to a surface (2424) between a first side (2409) of the seed holder unit (122) and a second side (2411) of the seed holder unit (122).

13. Furnace according to claim 11,
**characterized in that**
the repositioning element (2412) and the further gas inlet (2400) extend through sealed openings (2420) of the further-gas-sealing-unit (2408), and
the seed holder unit (122) comprises at least one hollow section or multiple hollow (2422) sections, wherein the further gas inlet (2400) and the hollow section or hollow sections (2422) are connected to guide gas through the tube and the hollow section or hollow sections (2422) to a surface (2424) between a first side (2409) of the seed holder unit (122) and a second side (2411) of the seed holder unit (122).

14. Furnace according to any of the before mentioned claims,
**characterized in that**
position adjustment unit (2398) for adjustment of the position of the seed holder unit (122) during operation of the furnace apparatus (100) comprises an actuator (2428), in particular a servo or step motor, wherein the motor is coupled to the at least one repositioning element (2412), wherein the repositioning element (2412) is preferably a rod or cylinder and
the actuator (2428) is arranged outside the crucible volume (116) and preferably outside the furnace volume (104), and
a control device (2430) for controlling operation of the actuator (2428) is provided, wherein the control device (2430) controls the actuator (2428) in dependency of sensor signals, in particular sensor signals of a weight sensor, and/or in dependency of time.

15. Method for producing SiC material,
at least comprising the steps:
Providing at least one furnace apparatus (100) according to any of the before mentioned claims, Arranging source material (120) in a receiving space (118) within the crucible housing (110), Heating the source material (120);
Adjusting the position of the seed holder unit (122) during operation of the furnace apparatus (100) for positioning a growth face (2426) of the growing SiC crystal (17) within a defined growth zone (2432).
